# EUROPEAN PATENT APPLICATION

(11) **EP 4 440 281 A1**
(43) Date of publication of application: **02.10.2024**
(21) Application number: 24166284.0
(22) Date of filing: 26.03.2024
(51) Int. Cl.: H10K 59/121, H10K 59/80

(54) **ELECTRONIC DEVICE**

(30) Priority: 29.03.2023 KR 20230041118; 06.11.2023 KR 20230151542
(71) Applicant: Samsung Display Co., Ltd., Yongin-si, Gyeonggi-do 17113 (KR)
(72) Inventor: LEE, Jeongho, 17113 Giheung-gu, Yongin-si (KR); LEE, Soyoung, 17113 Giheung-gu, Yongin-si (KR); PARK, JUNYEONG, 17113 Giheung-Gu, Yongin-si (KR)
(74) Representative: Dr. Weitzel & Partner

(57) **Abstract**

Provided is an electronic device. The electronic device includes a display module including a base layer, which includes a margin area and a pixel area, and pixels, and a cover organic layer. A module hole through which the display module and the cover organic layer, which overlap the margin area, pass is defined, the margin area is divided into a first area, a second area, and a third area that surrounds the module hole, and the display module includes dam patterns disposed on at least one of the first area or the second area. Each of the dam patterns includes a first insulating pattern, a first pattern disposed on the first insulating pattern, a second insulating pattern having an opening through which at least a portion of the first pattern is exposed, a second pattern disposed on the second insulating pattern and in contact with the first pattern through the opening, and a third insulating pattern configured to cover the second pattern.

## Description

### BACKGROUND

The present invention relates to an electronic device having improved quality.

Electronic devices are activated according to an electrical signal. Such an electronic device may include devices constituted by various electronic components such as a display panel displaying an image and an input sensor sensing an external input. The electronic components may be electrically connected to each other by signal lines, which are variously arranged.

### SUMMARY

The present inventio provides an electronic device having improved quality. The present invention is defined by the features of the independent claims. The dependent claims describe preferred embodiments.

An embodiment of the invention provides an electronic device including: a display module including a base layer, which includes a margin area and a pixel area that surrounds the margin area, and pixels disposed on the pixel area; and a cover organic layer disposed on the display module and overlapping the margin area, wherein a module hole is defined by passing through the display module and the cover organic layer, the margin area is divided into a first area adjacent to the pixel area, a second area that is surrounded by the first area, and a third area that surrounds the module hole and is disposed between the second area and the module hole, and the display module includes dam patterns disposed on at least one of the first area and the second area, wherein each of the dam patterns includes a first insulating pattern, a first pattern disposed on the first insulating pattern, a second insulating pattern having an opening exposing at least a portion of the first pattern, a second pattern disposed on the second insulating pattern and in contact with the first pattern through the opening, and a third insulating pattern configured to cover the second pattern.

In an embodiment, a width from the module hole to the second area may be about 200 um or more and about 400 um or less.

In an embodiment, a width from the module hole to the third area may be about 50 um or more and about 150 um or less.

In an embodiment, at least one of one side and the other side, which face each other, of the second pattern may protrude between the second insulating pattern and the third insulating pattern. In other words, at least one of two opposing sides of the second pattern may protrude outward from between the second insulating pattern and the third insulating pattern.

In an embodiment, each of the dam patterns may be surround the module hole.

In an embodiment, the display module may include: a first insulating layer disposed on the base layer; a first shielding electrode disposed on the first insulating layer; a second insulating layer configured to cover the first shielding electrode and disposed on the first insulating layer; a second shielding electrode disposed on the second insulating layer and overlapping the first shielding electrode; a third insulating layer configured to cover the second shielding electrode and disposed on the second insulating layer; a semiconductor pattern disposed on the third insulating layer; a fourth insulating layer disposed on a portion of the semiconductor pattern; a gate disposed on the fourth insulating layer; a fifth insulating layer configured to cover the gate; a first connection electrode disposed on the fifth insulating layer and connected to the semiconductor pattern through a first contact hole defined in the fifth insulating layer; a sixth insulating layer configured to cover the first connection electrode and disposed on the fifth insulating layer; a second connection electrode disposed on the sixth insulating layer and connected to the first connection electrode through a second contact hole defined in the sixth insulating layer; a seventh insulating layer configured to cover the second connection electrode and disposed on the sixth insulating layer; and a light emitting element disposed on the seventh insulating layer and connected to the second connection electrode.

In an embodiment, each of the first to fifth insulating layers may include an inorganic material, and each of the sixth insulating layer and the seventh insulating layer may include an organic material.

In an embodiment, at least one of the dam patterns disposed on the first area may further include: a first dummy pattern disposed between the second insulating layer and the third insulating layer; and a second dummy pattern that overlaps the first dummy pattern and is disposed between the third insulating layer and the fifth insulating layer.

In an embodiment, the first pattern may include a same material as the first connection electrode, the second pattern may include a same material as the second connection electrode, the first insulating pattern may include a same material as the fifth insulating layer, the second insulating pattern may include a same material as the sixth insulating layer, and the third insulating pattern may include the same material as the seventh insulating layer.

In an embodiment, the first connection electrode may be connected to the second shielding electrode through a contact hole defined in the third insulating layer and the fifth insulating layer.

In an embodiment, the display module may further include an encapsulation layer including a first encapsulating inorganic layer configured to cover the light emitting element, an encapsulating organic layer disposed on the first encapsulating inorganic layer, and a second encapsulating inorganic layer disposed on the encapsulating organic layer, and the dam patterns may be covered by the first encapsulating inorganic layer.

In an embodiment, the dam patterns disposed on the first area may overlap the encapsulating organic layer, and the dam patterns disposed on the second area may be spaced apart from the encapsulating organic layer.

In an embodiment, the first encapsulating inorganic layer configured to cover the dam patterns may be in contact with the second encapsulating inorganic layer on the second area.

In an embodiment, the display module may further include blocking patterns each of which surrounds the module hole and which are spaced apart from each other, wherein each of the blocking patterns may include at least one of: a first pattern layer including the same material as the first insulating layer; a second pattern layer including the same material as the second insulating layer; a third pattern layer including the same material as the third insulating layer; or a fourth pattern layer including the same material as the fifth insulating layer.

In an embodiment, the blocking patterns may be spaced apart from each other to expose a top surface of the base layer.

In an embodiment, the first encapsulating inorganic layer may be configured to cover the top surface of the base layer, which is exposed from the blocking patterns.

In an embodiment, the electronic device may further include a tip pattern disposed on the blocking patterns, wherein the tip pattern may include a first pattern and a second pattern, which are sequentially laminated, each of the first pattern and the second pattern may include a first conductive pattern, a second conductive pattern disposed on the first conductive pattern, and an intermediate pattern disposed between the first conductive pattern and the second conductive pattern, and the first conductive pattern and the second conductive pattern may protrude outward from the intermediate pattern.

In an embodiment, each of the first conductive pattern and the second conductive pattern may include titanium, and the intermediate pattern may include aluminum.

In an embodiment, the electronic device may further include an electronic module that overlaps the module hole and is disposed below the display module.

In an embodiment of the invention, an electronic device includes: a display module comprising a display panel and an input sensor, the display panel including a base layer, which includes a margin area and a pixel area that surrounds the margin area, a driving element layer including first to seventh insulating layer and a transistor, which are disposed on the base layer, a light emitting element layer including a pixel defining layer and a light emitting element, which are disposed on the driving element layer, and an encapsulation layer configured to cover the light emitting element; and the input sensor disposed on the display panel, wherein a module hole is defined by passing through the display module and a cover organic layer that is disposed on the display module and overlaps the margin area, the margin area is divided into a first area adjacent to the pixel area, a second area that is surrounded by the first area, and a third area that surrounds the module hole and is disposed between the second area and the module hole, and the display panel includes dam patterns disposed on at least one of the first area and the second area and blocking patterns disposed on the third area, wherein each of the blocking patterns includes a first pattern layer disposed on the base layer and a second pattern layer disposed on the first pattern layer, and the blocking patterns are spaced apart from each other to surround the module hole. The input sensor may be configured to sense a user's input such as a touch input.

In an embodiment, each of the first to fifth insulating layers may include an inorganic material, each of the sixth insulating layer and the seventh insulating layer may include an organic material, the first pattern layer may include a same material as the first insulating layer, and the second pattern layer may include a same material as the second insulating layer.

In an embodiment, each of the dam patterns may include a first insulating pattern disposed on the third insulating layer, a first pattern disposed on the first insulating pattern, a second insulating pattern in which an opening exposing at least a portion of the first pattern is defined, a second pattern disposed the second insulating pattern and in contact with the first pattern through the opening, and a third insulating pattern configured to cover the second pattern, the first insulating pattern may include a same material as the fifth insulating layer, the second insulating pattern may include a same material as the sixth insulating layer, and the third insulating pattern may include a same material as the seventh insulating layer.

In an embodiment, at least one of the dam patterns disposed on the first area may further include: a first dummy pattern disposed between the second insulating layer and the third insulating layer; and a second dummy pattern that overlaps the first dummy pattern and is disposed between the third insulating layer and the first insulating pattern.

In an embodiment, the encapsulation layer may include a first encapsulating inorganic layer configured to cover the light emitting element, a second encapsulating inorganic layer disposed on the first encapsulating inorganic layer, and an encapsulating organic layer disposed between the first encapsulating inorganic layer and the second encapsulating inorganic layer, and the electronic device may further include a planarization layer disposed between the second encapsulating inorganic layer and the input sensor.

In an embodiment, the blocking pattern may be configured to prevent peeling that occurs in the first to seventh insulating layers during a laser process of forming the module hole from occurring.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is perspective view of an electronic device according to an embodiment of the inventive concept;
FIG. 2 is an exploded perspective view of the electronic device according to an embodiment of the inventive concept;
FIG. 3 is a block diagram of the electronic device according to an embodiment of the inventive concept;
FIG. 4 is a plan view of a display panel adjacent to a hole according to an embodiment of the inventive concept;
FIG. 5 is a cross-sectional view taken along line I-I' of FIG. 2;
FIG. 6A is a cross-sectional view taken along line II-II' of FIG. 2;
FIG. 6B is a cross-sectional view of a dam pattern according to an embodiment of the inventive concept;
FIG. 7A is a cross-sectional view of a display panel according to an embodiment of the inventive concept;
FIG. 7B is a cross-sectional view of a display panel according to an embodiment of the inventive concept;
FIG. 8A is a cross-sectional view of a display panel according to an embodiment of the inventive concept;
FIG. 8B is an enlarged plan view of an area AA' of FIG. 8A; and
FIGS. 9A and 9B are cross-sectional views illustrating a process of forming a module hole in an electronic device according to an embodiment of the inventive concept.

### DETAILED DESCRIPTION

In this specification, it will also be understood that when one component (or area, layer, portion) is referred to as being 'on', `connected to', or `coupled to' another component, it can be directly disposed/connected/coupled on/to the one component, or an intervening third component may also be present.

Like reference numerals refer to like elements throughout. Also, in the figures, the thickness, ratio, and dimensions of components are exaggerated for clarity of illustration. The term "and/or" includes any and all combinations of one or more of the associated elements.

It will be understood that although the terms such as 'first' and 'second' are used herein to describe various elements, these elements should not be limited by these terms. These terms are used only to distinguish one component from other components. For example, a first element referred to as a first element in an embodiment can be referred to as a second element in another embodiment without departing from the scope of the appended claims. The terms of a singular form may include plural forms unless referred to the contrary.

Also, ""under", "below", "above', "upper", and the like are used for explaining relation association of the elements illustrated in the drawings. The terms may be a relative concept and described based on directions expressed in the drawings.

The meaning of `include' or 'comprise' specifies a property, a fixed number, a process, an operation, an element, a component or a combination thereof, but does not exclude other properties, fixed numbers, processes, operations, elements, components or combinations thereof.

Unless otherwise defined, all terms (including technical and scientific terms) used herein have the same meaning as commonly understood by a person of ordinary skill in the art to which the inventive concept belongs. In addition, terms such as terms defined in commonly used dictionaries should be interpreted as having a meaning consistent with the meaning in the context of the related technology, and unless explicitly defined here, they are interpreted as too ideal or too formal sense.

Hereinafter, embodiments of the inventive concept will be described with reference to the accompanying drawings.

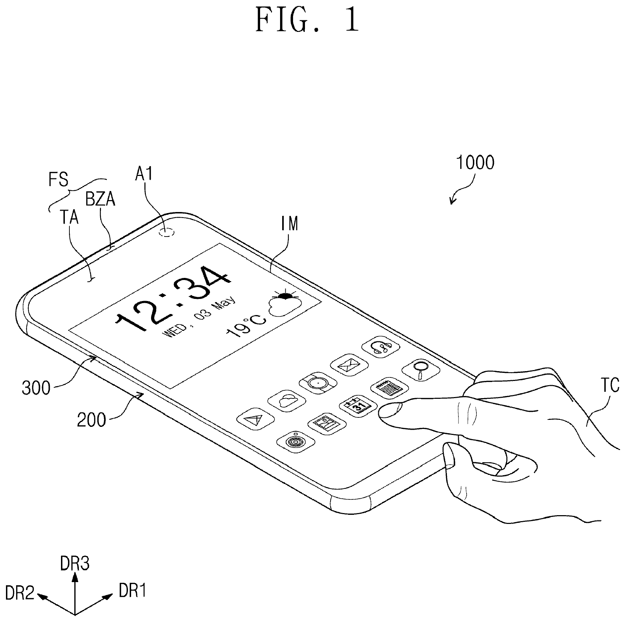

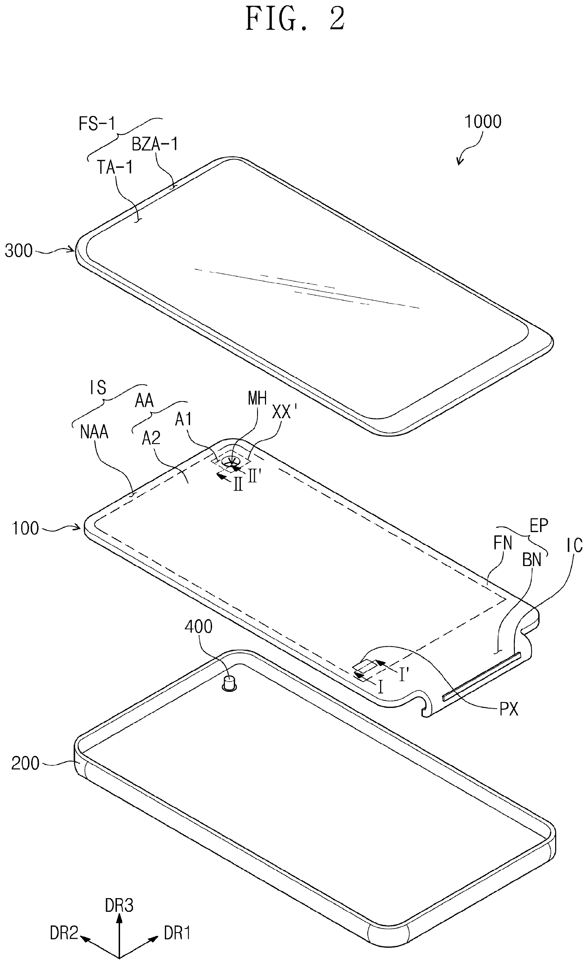

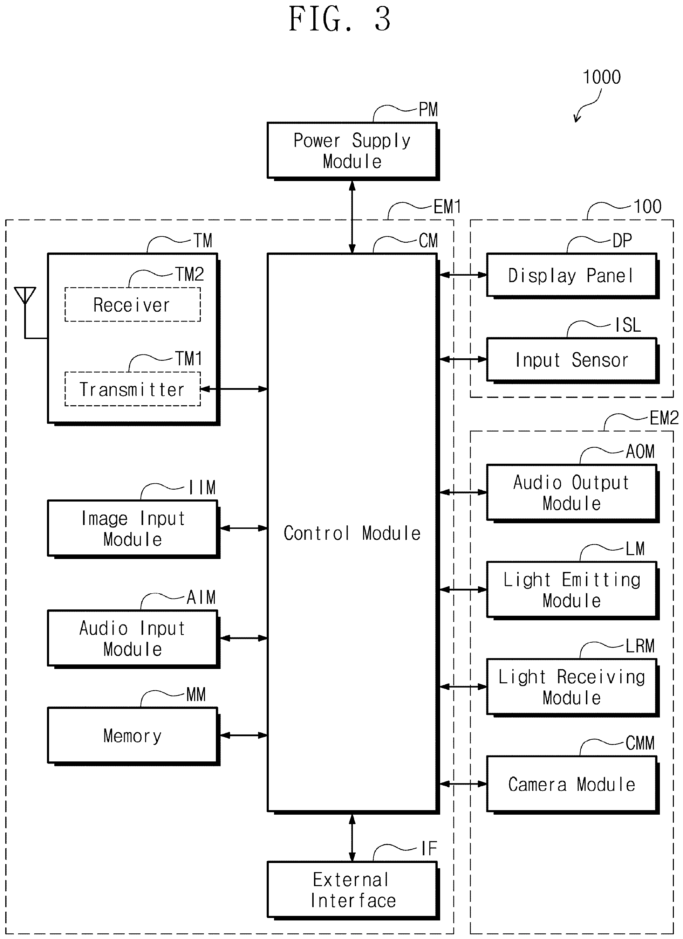

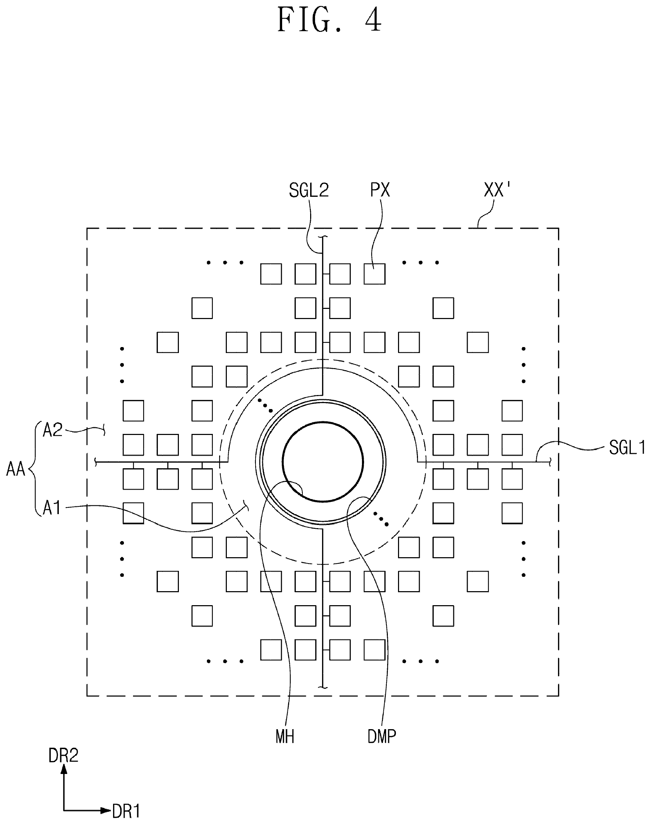

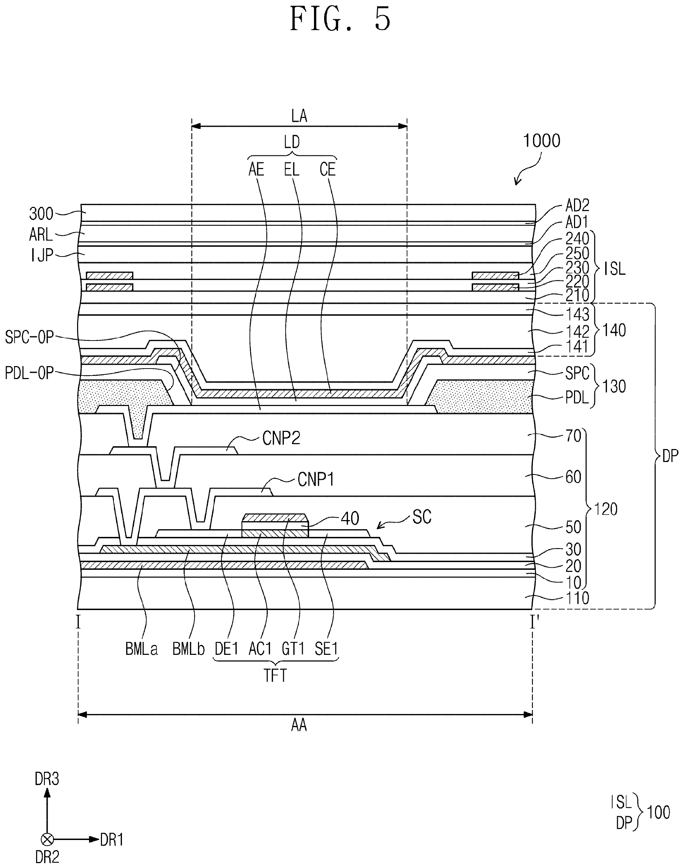

FIG. 1 is perspective view of an electronic device according to an embodiment of the inventive concept. FIG. 2 is an exploded perspective view of an electronic device according to an embodiment of the inventive concept. FIG. 3 is a block diagram of the electronic device according to an embodiment of the inventive concept. FIG. 4 is a plan view of a display panel adjacent to a hole according to an embodiment of the inventive concept. FIG. 5 is a cross-sectional view taken along line I-I' of FIG. 2.

As illustrated in FIG. 1, an electronic device 1000 may display an image IM in a third direction DR3 on a display surface FS that is parallel to each of first and second directions DR1 and DR2. The display surface FS on which the image IM is displayed may correspond to a front surface of the electronic device 1000. The display surface FS may include a light transmission area TA and a bezel area BZA surrounding at least a portion of the light transmission area TA.

The electronic device 1000 may provide a dynamic image IM and a static image IM to a user through the display surface FS and may detect an external input TC. In FIG. 1, the image IM is illustrated as a watch and a plurality of icons as an example. The display surface FS of the electronic device 1000 may correspond to a front surface FS-1 of a window 300. Thus, the light transmission area TA may be defined to correspond to a light transmission area TA-1 of the window 300, and the bezel area BZA may be defined to correspond to a bezel area BZA-1 of the window 300. In this embodiment, a front surface (or a top surface) or a rear surface (or a bottom surface) of each of members may be defined based on a direction in which the image IM is displayed. The front and rear surfaces may be opposite to each other in the third direction DR3. A normal direction of each of the front and rear surfaces may be parallel to the third direction DR3. A spaced distance between the front and rear surfaces in the third direction DR3 may correspond to a thickness of the electronic device 1000 in the third direction DR3.

The electronic device 1000 according to an embodiment of the inventive concept may sense a user's input TC applied from the outside. The user's input TC includes various types of external inputs such as a portion of user's body, light, heat, a pressure, or the like. In this embodiment, the user's input TC is illustrated as a user's hand applied to the front surface FS-1 of the window 300.

However, this is merely an example. For example, as described above, the user's input TC may be provided in various forms. The electronic device 1000 may sense the user's input TC applied to a side surface or the rear surface of the electronic device 1000 according to a structure of the electronic device 1000, but is not limited to a specific embodiment.

The electronic device 1000 according to an embodiment may include a margin area A1 that overlaps the light transmission area TA. The margin area A1 may be defined as an area of a display module 100 (see FIG. 2) in which an electronic module 400 (see FIG. 2), which will be described later, is disposed. A module hole MH (see FIG. 2) of the display module 100 may be defined in the margin area A1.

The electronic device 1000 may receive an external signal required for the electronic module 400 through the margin area A1 or may provide a signal output from the electronic module 400 to the outside. According to an embodiment of the inventive concept, since the margin area A1 may be provided inside the light transmission area TA, a surface area of a bezel area BZA that defines the margin area A1 may be reduced.

Referring to FIG. 2, the electronic device 1000 may include a display module 100, a housing 200, a window 300, and an electronic module 400. The window 300 and the housing 200 may be coupled to each other to define an outer appearance of the electronic device 1000. The electronic device 1000 according to an embodiment may further include a cover organic layer IJP (see FIG. 5) and an anti-reflection layer ARL (see FIG. 5) disposed on the display module 100. This will be described later.

The window 300 may include an insulation panel. For example, the window 300 may be made of glass, plastic, or a combination thereof. As described above, the front surface FS of the window 300 may define the front surface FS of the electronic device 1000. The window 300 may include the light transmission area TA-1 and the bezel area BZA-1 adjacent to the light transmission area TA-1. The light transmission area TA-1 may be an optically transparent area. For example, the light transmission area TA-1 may be an area having a visible light transmittance of about 90% or more. The bezel area BZA-1 may be an area having light transmittance that is relatively less than that of the light transmission area TA-1. The bezel area BZA-1 defines a shape of the light transmission area TA-1.

The bezel area BZA-1 may have a predetermined color. The bezel area BZA-1 may be defined by a bezel layer provided separately from a transparent substrate defining the light transmission area TA-1, or by an ink layer inserted into or applied on the transparent substrate.

The display module 100 may include an electronic panel EP and a driving circuit IC. The electronic panel EP may display the image IM and sense the user's input TC, especially a touch input. A front surface IS of the electronic panel EP includes an active area AA and a peripheral area NAA.

In this embodiment, the active region AA may have an area on which the image IM is displayed, and also, the external input TC is sensed. The active area AA may be an area on which a plurality of pixels PX are disposed.

According to an embodiment of the inventive concept, the active area AA may include the margin area A1 and a pixel area A2 surrounding at least a portion of the margin area A1. The pixels PX may be disposed on the pixel area A2 of the active area AA. The module hole MH passing from the front surface IS to a rear surface of the electronic panel EP may be defined on the margin area A1. The electronic module 400 disposed below the electronic panel EP may overlap the module hole MH defined in the margin area A1.

The active area AA overlaps at least a portion of the light transmission area TA. For example, the light transmission area TA overlaps the front surface or at least a portion of the active area AA. Thus, the user may visually recognize the image IM through the light transmission area TA or provide the external input TC. However, this is merely an example. For example, an area of the active region AA, on which the image IM is displayed, and an area of the active region AA, on which the external input TC is sensed, may be separated from each other, but is not limited to a specific embodiment.

The peripheral region NAA may be an area covered by the bezel area BZA. The peripheral area NAA is adjacent to the active area AA. The peripheral region NAA may surround the active region AA. The peripheral area NAA may be an area on which the image IM is not displayed. A driving circuit or a driving line for driving the active area AA may be disposed in the peripheral area NAA.

In this embodiment, a portion of the peripheral area NAA of the electronic panel EP may be bent. For example, the electronic panel EP may include a flat part FN and a bent part BN. The flat part FN may be assembled in a state of being substantially parallel to a plane defined by the first and second directions DR1 and DR2. The active area AA may be provided on the flat part FN.

The bent part BN may extend from the flat part FN and may be bent along a virtual bending axis. The bent part BN may be bent to face a rear surface of the flat part FN and then assembled with the flat part FN. When assembled, since the bent part BN overlaps the flat part FN on a plane, the bezel area BZA of the electronic device 1000 may be reduced. This is merely an example, and in the electronic panel EP, the bent part BN may be omitted.

The driving circuit IC may be mounted on the bent part BN. The driving circuit IC is shown as an embodiment provided in the form of a chip, but is not limited thereto, and may be provided on a separate circuit board to be electrically connected to the electronic panel EP through a flexible film or the like.

The driving circuit IC may be electrically connected to the active area AA to transmit an electrical signal to the active area AA. For example, the driving circuit IC may include a data driving circuit and provide data signals to the pixels PX disposed on the active area AA. Alternatively, the driving circuit IC may include a touch driving circuit and may be electrically connected to an input sensor disposed on the active area AA. This is merely an example, and the driving circuit IC may include various circuits in addition to the above-described circuits or may be designed to provide various electrical signals to the active area AA, but is not limited to a specific embodiment.

The electronic device 1000 according to an embodiment may further include a main circuit board electrically connected to the electronic panel EP and the driving circuit IC. The main circuit board may include various driving circuits that drive the electronic panel EP and a connector for supplying power. The main circuit board may be a rigid printed circuit board (PCB), but is not limited thereto, and may also be a flexible circuit board, but is not limited to a specific embodiment.

The electronic module 400 is disposed below the display module 100. The electronic module 400 may overlap the module hole MH defined in the electronic panel EP and may receive an external input transmitted through the module hole MH or output a signal through the module hole MH.

Although FIG. 2 illustrates a single module hole MH having a circular shape as an example, but this embodiment is not limited thereto. For example, the number of module holes MH may be defined in the electronic panel EP to correspond to the number of electronic modules 400 disposed below the electronic panel EP, and the module hole MH may have either a polygonal shape or an oval shape, but is not limited thereto.

According to an embodiment of the inventive concept, the electronic module 400 may be disposed to overlap the active area AA by providing the margin area A1 having a relatively high transmittance inside the active area AA. Thus, the bezel area BZA may be prevented from increasing.

A housing 200 may be coupled to the window 300 to provide a predetermined internal space and define an outer appearance of the electronic device 1000. Components of the electronic device 1000, such as the display module 100 and the electronic module 400, may be accommodated in the internal space.

The housing 200 may include a material having relatively high rigidity. For example, the housing 200 may include glass, plastic, or a metal or may include a plurality of frames and/or plates made of a combination of glass, plastic, and a metal. The housing 200 may stably protect components of the electronic device 1000 accommodated in the internal space from external impact.

Referring to FIG. 3, the electronic device 1000 may include the display module 100, a power supply module PM, a first electronic module EM1, and a second electronic module EM2. The display module 100, the power supply module PM, the first electronic module EM1, and the second electronic module EM2 may be electrically connected to each other.

In FIG. 3, the display panel DP and the input sensor ISL among the components of the display module 100 are illustrated as an example. The display panel DP may be a component that generates the image IM. The image IM generated by the display panel DP is displayed on the display surface FS through the light transmission area TA and is visually recognized by the user from the outside. The input sensor ISL senses the external input TC, such as a touch input, applied from the outside. As described above, the input sensor ISL may sense the external input TC provided to the window 300.

The power supply module PM supplies power required for an overall operation of the electronic device 1000. The power supply module PM may include a general battery module.

The first electronic module EM1 and the second electronic module EM2 may include various functional modules for driving the electronic device 1000. The first electronic module EM1 may be directly mounted on a mother board electrically connected to the electronic panel EP or may be mounted on a separate board and electrically connected to the mother board through a connector (not shown).

The first electronic module EM1 may include a control module CM, a wireless communication module TM, an image input module IIM, an audio input module AIM, a memory MM, and an external interface IF. A portion of the modules may not be mounted on the mother board but electrically connected to the mother board through a flexible circuit board.

The control module CM controls an overall operation of the electronic device 1000. The control module CM may be a micro processor. For example, the control module CM may activate or inactivate the display module 100. The control module CM may control other modules such as the image input module IIM or the audio input module AIM on the basis of a touch signal received from the electronic panel EP.

The wireless communication module TM may transmit/receive a wireless signal to/from the other terminal by using Bluetooth or Wi-Fi line. The wireless communication module TM may transmit/receive an audio signal by using a general communication line. The wireless communication module TM includes a transmitter TM1 modulating and transmitting a signal to be transmitted and a receiver TM2 demodulating the received signal.

The image input module IIM processes the image signal to convert the processed image signal into image data that is capable of being displayed on the electronic panel EP. The audio input module AIM receives external audio signals by using a microphone during recording mode or a voice recognition mode to convert the received audio signal into electrical sound data.

The external interface IF serves as an interface connected to an external charger, a wired/wireless data port, and a card socket (for example, a memory card and an SIM/UIM card).

The second electronic module EM2 may include an audio output module AOM, a light emitting module LM, a light receiving module LRM, and a camera module CMM. The above-described constituents may be directly mounted on the mother board, may be mounted on a separate board and electrically connected to the electronic panel EP through a connector (not shown), or may be electrically connected to the first electronic module EM1.

The audio output module AOM converts audio data received from the wireless communication module TM or audio data stored in the memory MM to output the converted audio data to the outside.

The light emitting module LM generates and outputs light. The light emitting module LM may output infrared rays. The light emitting module LM may include an LED. The light receiving module LRM may sense the infrared rays. The light receiving module LRM may be activated when infrared rays having a predetermined level or more is sensed. The light receiving module LRM may include a CMOS sensor. The infrared rays generated in the light emitting module LM may be outputted and then be reflected by an external object (for example, a user's finger or face), and the reflected infrared rays may be incident into the light receiving module LRM. The camera module CMM photographs an external image.

The electronic module 400 according to an embodiment of the inventive concept may include at least one of components of the second electronic module EM2. For example, the electronic module 400 may include at least one of a camera, a speaker, an optical detection sensor, or a thermal detection sensor. The electronic module 400 may sense an external subject received through the margin area A1 or provide a sound signal such as voice to the outside through the margin area A1. Also, the electronic module 400 may include a plurality of constituents, but is not limited to a specific embodiment. Although not shown, the electronic module 400 may be attached to the electronic panel EP through a separate adhesive.

FIG. 4 illustrates a portion XX' of the active area AA adjacent to the module hole MH of the display panel DP (see FIG. 3).

Referring to FIG. 4, most of the pixels PX provided in the display panel DP may be disposed on the pixel area A2, and some of the pixels PX may be disposed on the pixel area A2 along a boundary between the margin area A1 and the pixel area A2 and spaced apart from the margin area A1.

The module hole MH may be defined in the active area AA. Thus, at least a portion of the pixels PX may be disposed adjacent to the module hole MH and spaced apart from each other with the module hole MH therebetween.

At least one dam pattern DMP may be disposed on the margin area A1 of the display panel DP. According to an embodiment, the electronic device 1000 (see FIG. 2) may block a path through which moisture and/or oxygen is introduced from the module hole MH to the pixels PX by the dam pattern DMP. In addition, in a process of forming the module hole MH, an etchant may be prevented from being introduced into the display panel DP through the module hole MH. Thus, the display panel DP having improved quality may be provided. A detailed description of the dam pattern DMP will be provided later.

The dam pattern DMP may be disposed on the margin area A1 and may surround at least a portion of the module hole MH. On a plane, the dam pattern DMP may have a closed-line shape surrounding the module hole MH.

According to an embodiment, a filler may be disposed inside the module hole MH. The filler may include a polymer resin. As the filler is disposed inside the module hole MH, a flat surface may be provided to a component disposed on the module hole MH.

A portion of each of the plurality of signal lines SGL1 and SGL2 connected to the pixels PX may be disposed on the margin area A1. The signal lines SGL1 and SGL2 are connected to the pixels PX spaced apart from each other with the module hole MH therebetween via the margin area A1. In FIG. 4, for convenience of description, two signal lines SGL1 and SGL2 among the plurality of signal lines connected to the pixels PX are illustrated as an example.

The first signal line SGL1 extends in the first direction DR1. The first signal line SGL1 is connected to the pixels within the same row arranged in the first direction DR1 of the pixels PX. The first signal line SGL1 will be exemplarily described as corresponding to any one of scan lines connected to the pixels PX.

A portion of the pixels PX connected to the first signal line SGL1 may be disposed at the left side of the module hole MH, and other portion of the pixels PX may be disposed at the right side of the module hole MH. Thus, the pixels in the same row connected to the first signal line SGL1 may be turned on/off by substantially the same gate signal even though a portion of the pixels PX with respect to the module hole MH is omitted.

The second signal line SGL2 extends in the second direction DR2. The second signal line SGL2 is connected to the pixels of the pixels PX in the same column arranged in the second direction DR2. The second signal line SGL2 will be exemplarily described as corresponding to any one of the data lines connected to the pixels PX.

A portion of the pixels PX connected to the second signal line SGL2 may be disposed above the module hole MH, and other portion of the pixels PX may be disposed below the module hole MH. Thus, the pixels in the same row connected to the second signal line SGL2 may receive a data signal through the same line even though a portion of the pixels with respect to the module hole MH is omitted.

At least one of the first signal line SGL1 or the second signal line SGL2 may be disconnected within the margin area A1 at a point at which the first signal line SGL1 and the second signal line SGL2 cross each other, and a connection pattern disposed on a different layer from the disconnected signal line to connect the disconnected portions may be further provided. However, the connection relationship between the pixels PX spaced apart with the module hole MH therebetween is not limited thereto.

FIG. 5 is a cross-sectional view taken along line I-I' of FIG. 2. In FIG. 5, the housing 200 described in FIG. 1 is omitted. FIG. 5 illustrates a cross section of the electronic device 1000 corresponding to the pixel PX described in FIG. 2.

Referring to FIG. 5, the electronic device 1000 according to an embodiment may include a display module 100, a cover organic layer IJP, an anti-reflection layer ARL, the housing 200 described in FIG. 2, and a window 300. The display module 100 may include a display panel DP and an input sensor ISL.

The pixel PX described in FIG. 2 may include a light emitting element LD and a pixel driving circuit. The pixel driving circuit may include a plurality of transistors and a capacitor. FIG. 5 illustrates one transistor TFT provided in the pixel PX, which is described in FIG. 2, as an example. According to an embodiment, the transistors provided in the pixel PX (see FIG. 2) may be oxide semiconductors. For example, each of the transistors may include a semiconductor layer containing metal oxide. However, the configuration of the pixel driving circuit is not necessarily limited thereto. Some of the transistors provided in the pixel driving circuit may include silicon transistors, and others may include oxide transistors.

The display panel DP may include a base layer 110, a driving element layer 120, a light emitting element layer 130, and an encapsulation layer 140.

The base layer 110 may provide a base surface on which the driving element layer 120, the light emitting element layer 130, and the encapsulation layer 140 are disposed. The base layer 110 may be flexible or rigid. For example, the base layer 110 may include a synthetic resin film or one of glass and metal. Although FIG. 5 illustrates a single-layer base layer 110, this embodiment is not limited thereto, and the base layer 110 may be provided as a multi-layered structure in which a plurality of organic layers and a plurality of inorganic layers are alternated.

A first insulating layer 10 (barrier layer) may be disposed on the base layer 110. The first insulating layer 10 prevents foreign substances from being introduced from the outside. The first insulating layer 10 may include at least one inorganic layer.

According to an embodiment, each of first to fifth insulating layers 10, 20, 30, 40, and 50 may include single-layer or multi-layered inorganic layers. For example, each of the first to third insulating layers 10, 20, and 30 may be provided as a single layer including a silicon nitride layer, a silicon oxynitride layer, a silicon oxide layer, a titanium oxide layer, or an aluminum oxide layer, or may be provided as a multiple layer in which two or more layers of the above-described layers are laminated.

A first shielding electrode BMI,a may be disposed on the first insulating layer 10. The first shielding electrode BMLa may be disposed to overlap the transistor TFT. The first shielding electrode BMLa may include a metal. For example, the first shielding electrode BMLa may include at least one of titanium, aluminum, molybdenum, copper, and silver, or an alloy thereof. The first shielding electrode BMLa may be provided as a single layer or as a multiple layer. For example, the first shielding electrode BMLa may include metal layers of a first layer disposed on the base layer 110 and a second layer disposed on the first layer. The first layer may include aluminum, and the second layer may include titanium. However, this embodiment is not limited thereto, and the first shielding electrode BMI,a may be provided in three or more layers.

The first shielding electrode BMI,a may block external light from reaching the transistor TFT. In an embodiment of the inventive concept, the first shielding electrode BMI,a may be a floating electrode that is isolated from other electrodes or lines.

The second insulating layer 20 may cover the first shielding electrode BMLa and may be disposed on the first insulating layer 10. The second insulating layer 20 may prevent metal atoms or impurities from being diffused from the base layer 110 to a semiconductor pattern SC.

The second shielding electrode BMLb may be disposed on the second insulating layer 20. The second shielding electrode BMLb may be disposed to overlap the first shielding electrode BMI,a. The second shielding electrode BMLb may include a metal. For example, the second shielding electrode BMLb may include at least one of titanium, aluminum, molybdenum, copper, and silver, or an alloy thereof. The second shielding electrode BMLb may be provided as a single layer or as a multiple layer. For example, second shielding electrode BMLb may include metal layers of a first layer disposed on the first insulating layer 20 and a second layer disposed on the first layer. The first layer may include aluminum, and the second layer may include titanium. However, this embodiment is not limited to this, and the second shielding electrode BMLb may be provided in three or more layers.

The second shielding electrode BMLb may receive a bias voltage. The second shielding electrode BMLb may receive a first power voltage. The second shielding electrode BMI,b may block an electrical potential due to polarization from affecting the transistor TFT. In an embodiment of the inventive concept, the second shielding electrode BMLb may be connected to a portion of the semiconductor pattern SC through the first connection electrode CNP1.

The third insulating layer 30 (buffer layer) may cover the second shielding electrode BMLb and may be disposed on the second insulating layer 20. The third insulating layer 30 may improve coupling force between the base layer 110 and the semiconductor pattern SC and/or a conductive pattern.

The semiconductor pattern SC may be disposed on the third insulating layer 30. The semiconductor pattern SC may include metal oxide. The metal oxide semiconductor may include a crystalline or amorphous oxide semiconductor. For example, the oxide semiconductor may include metal oxide such as zinc (Zn), indium (In), gallium (Ga), tin (Sn), titanium (Ti), or metals such as zinc (Zn), indium (In), gallium (Ga), tin (Sn), and a mixture of their oxide. The oxide semiconductor may include indium-tin oxide (ITO), indium-gallium-zinc oxide (IGZO), zinc oxide (ZnO), indium-zinc oxide (IZO), indium oxide (InO), titanium oxide (TiO), indium-zinc-tin oxide (IZTO), zinc-tin oxide (ZTO), and the like.

However, this embodiment is not limited thereto, and the semiconductor pattern SC may include a silicon semiconductor. For example, the silicon semiconductor may include amorphous silicon, polycrystalline silicon, and the like. For example, the semiconductor pattern SC may include low-temperature polysilicon.

The semiconductor pattern SC has different electrical properties depending on whether the semiconductor pattern SC is doped. The semiconductor pattern SC may include a first region having high conductivity and a second region having low conductivity. The first region may be doped with an N-type dopant or a P-type dopant. A P-type transistor may include a doped region doped with the P-type dopant, and an N-type transistor may include a doped region doped with the N-type dopant. The second region may be a non-doped region or may be doped at a concentration less than that of the first region.

The first region may have conductivity greater than that of the second region and may substantially serve as an electrode or a signal line. The second region may substantially correspond to a channel region (or active region) of the transistor. That is, one portion of the semiconductor pattern SC may be a channel of the transistor, the other portion may be a source or drain region of the transistor, and another portion may be a connection electrode or a connection signal line.

The oxide semiconductor may include a plurality of regions SE1, AC1, and DE1 divided depending on whether the transparent conductive oxide has been reduced. A region in which the transparent conductive oxide is reduced (hereinafter, referred to as a reduction region) has conductivity higher than that of a region in which the transparent conductive oxide is not reduced (hereinafter, referred to as a non-reduction region). The reduction region substantially serves as a source/drain of a transistor or a signal line. The non-reduction region substantially corresponds to a semiconductor region (or channel) of the transistor. That is, a partial region of the semiconductor pattern SC may be the channel region AC1 of the transistor, the other region may be the source region SE1/drain region DE1 of the transistor, and another region may be a signal transmission region.

The source region SE1, the channel region AC1 (or active region), and drain region DE1 of the transistor TFT may be formed from the semiconductor pattern SC. The source region SE1 and the drain region DE1 may extend in opposite directions from the channel region AC1 in a cross-section.

The fourth insulating layer 40 may overlap the channel region AC1. The fourth insulating layer 40 may be patterned using a gate GT1 disposed on the fourth insulating layer 40 as a mask.

The gate GT1 may be disposed on the fourth insulating layer 40. The gate GT1 overlaps the channel region AC1. The gate GT1 may be a portion of a metal pattern. In a process of doping the semiconductor pattern SC, the gate GT1 may be a mask. The gate GT1 may include at least one of molybdenum and copper. However, this embodiment is not limited thereto, and the gate GT1 may include a metal layer including first to third layers that are sequentially laminated on the fourth insulating layer 40. The first and third layers may include titanium, and the second layer may include aluminum.

The capacitor provided in the pixel PX (see FIG. 2) may include electrodes disposed on different layers. The electrodes may be branched from any one of the first shielding electrode BMI,a, the second shielding electrode BMI,b, and the gate GT1 or may be formed through the same process.

The fifth insulating layer 50 may cover the gate GT1 and may be disposed on the third and fourth insulating layers 30 and 40. According to an embodiment, the fifth insulating layer 50 may be formed by alternately laminating a silicon oxynitride layer and a silicon nitride layer.

The first connection electrode CNP1 may be disposed on the fifth insulating layer 50. One portion of the first connection electrode CNP1 may be connected to the second shielding electrode BMI,b through a contact hole passing through the third and fifth insulating layers 30 and 50, and the other portion may be connected to the drain region DE1 through a contact hole passing through the fifth insulating layer 50.

The sixth insulating layer 60 (first interlayer insulating layer) may be disposed on the fifth insulating layer 50. The sixth insulating layer 60 may include polyimide.

The second connection electrode CNP2 may be disposed on the sixth insulating layer 60. The second connection electrode CNP2 may be connected to the first connection electrode CNP1 through a contact hole passing through the sixth insulating layer 60. A data line may be disposed on the sixth insulating layer 60.

Each of the first connection electrode CNP1 and the second connection electrode CNP2 may include a metal. For example, each of the first connection electrode CNP1 and the second connection electrode CNP2 may include at least one of titanium, aluminum, molybdenum, copper, and silver. Each of the first connection electrode CNP1 and the second connection electrode CNP2 may be provided as a single layer or may include metal layers including first to third layers that are sequentially laminated. The first and third layers may include titanium, and the second layer may include aluminum.

The seventh insulating layer 70 (second interlayer insulating layer) may cover the second connection electrode CNP2 and the data line and may be disposed on the sixth insulating layer 60. The seventh insulating layer 70 may include polyimide.

The light emitting element LD may include an anode AE (or first electrode), an emission layer EL, and a cathode CE (or second electrode). The anode AE of the light emitting element LD may be disposed on the seventh insulating layer 70. The anode AE may be a (semi)transmissive electrode or a reflective electrode. The anode AE may include a laminated structure of sequentially laminated ITO/Ag/ITO. A position of each of the anode AE and cathode CE may be changed.

A pixel defining layer PDL may be disposed on the seventh insulating layer 70. The pixel defining layer PDL may include an organic layer containing polyimide. The pixel defining layer PDL may have a property of absorbing light and may have, for example, a black color. The pixel defining layer PDL may include a black coloring agent. A black component may include a black dye and a black pigment. The black component may include carbon black, a metal such as chromium, or oxide thereof. The pixel defining layer PDL may correspond to a light blocking pattern having light blocking properties.

A first opening PDL-OP exposing a portion of the anode AE may be defined in the pixel defining layer PDL.

A spacer SPC may be disposed on the pixel defining layer PDL. The spacer SPC may prevent the pixel defining layer PDL, which is black component, from being visible to the outside, and a groove for fixing a support that supports the mask may be defined in a process of forming the emission layer EL through a deposition process. At least a portion of the spacer SPC may pass through the groove. The spacer SPC may be an organic layer containing polyimide. The spacer SPC according to an embodiment may be transparent. A second opening SPC-OP that exposes a portion of the anode AE to overlap the first opening PDL-OP may be defined in the spacer SPC. The light emitting area LA may be defined to correspond to the second opening SPC-OP.

The emission layer EL may be disposed inside the second opening SPC-OP and on the anode AE. In an embodiment of the inventive concept, a hole control layer may be disposed between the anode AE and the emission layer EL. The hole control layer may include a hole transport layer and may further include a hole injection layer. An electron control layer may be disposed between the emission layer EL and the cathode CE. The electron control layer may include an electron transport layer and may further include an electron injection layer.

The cathode CE (second electrode) is disposed on the emission layer EL. An electron control layer may be disposed between the emission layer EL and the cathode CE. The electron control layer may include an electron transport layer and an electron injection layer. The cathode CE is disposed on the electron control layer. The electron control layer, the hole control layer, and the cathode CE are commonly disposed in the plurality of pixels PX.

The encapsulation layer 140 may cover the light emitting element LD. The encapsulation layer 140 may include a first encapsulating inorganic layer 141, an encapsulating organic layer 142, and a second encapsulating inorganic layer 143, which are sequentially laminated, but the layers constituting the encapsulation layer 140 are not necessarily limited thereto. The encapsulating inorganic layers 141 and 143 may include a silicon nitride layer, a silicon oxy nitride layer, a silicon oxide layer, a titanium oxide layer, or an aluminum oxide layer. Each of the encapsulating inorganic layers 141 and 143 may have a multi-layered structure. The encapsulating organic layer 142 may include an acrylic-based organic layer, but is not limited thereto.

The input sensor ISL may include at least one conductive layer (or at least one sensor conductive layer) and at least one insulating layer (or at least one sensor insulating layer).

In this embodiment, the input sensor ISL may include a first insulating layer 210 (or first sensor insulating layer), a first conductive layer 220, a second insulating layer 230 (or second sensor insulating layer), a second conductive layer 240, and a third insulating layer 250 (or third sensor insulating layer). In FIG. 5, a conductive line of the first conductive layer 220 and a conductive line of the second conductive layer 240 are illustrated.

The first insulating layer 210 may be directly disposed on the display panel DP. The first insulating layer 210 may be an inorganic layer including at least one of silicon nitride, silicon oxynitride, or silicon oxide.

Each of the first conductive layer 220 and the second conductive layer 240 may have a single-layered structure or a multilayered structure in which a plurality of layers are laminated in the third directional axis DR3. The first conductive layer 220 and the second conductive layer 240 may include conductive lines defining mesh-shaped electrodes. The conductive line of the first conductive layer 220 and the conductive line of the second conductive layer 240 may be or may not be connected to each other through a contact hole passing through the second insulating layer 230. A connection relationship between the conductive line of the first conductive layer 220 and the conductive line of the second conductive layer 240 may be determined depending on the type of sensor that forms the input sensor ISL.

Each of the first conductive layer 220 and the second conductive layer 240, each of which has a single layer structure, may include a metal layer or a transparent conductive layer. The metal layer may include molybdenum, silver, titanium, copper, aluminum, or an alloy thereof. The transparent conductive layer may include transparent conductive oxide such as indium-tin oxide (ITO), indium-zinc oxide (IZO), zinc oxide (ZnOx), or indium zinc tin oxide (IZTO). In addition, the transparent conductive layer may include conductive polymers such as PEDOT, metal nanowires, graphene, and the like.

The first conductive layer 220 and the second conductive layer 240, each of which has a multi-layered structure, may include metal layers. The metal layers may have a three-layered structure of titanium/aluminum/titanium. The conductive layer having the multilayered structure may include at least one metal layer and at least one transparent conductive layer.

The second insulating layer 230 may be disposed between the first conductive layer 220 and the second conductive layer 240. The third insulating layer 250 may cover the second conductive layer 240. In an embodiment of the inventive concept, the third insulating layer 250 may be omitted. Each of the second insulating layer 230 and the third insulating layer 250 may include an inorganic layer or an organic layer. The input sensor ISL may be disposed on the display panel DP. For example, the input sensor ISL may be disposed on the second encapsulating inorganic layer 143.

The cover organic layer IJP may be disposed on the input sensor ISL. The cover organic layer IJP may compensate for a height difference occurring during the process of forming the display panel DP and the input sensor ISL. Thus, a flat surface may be provided to the components disposed on the display panel DP. The cover organic layer IJP may include an organic material. The cover organic layer IJP may be formed on the input sensor ISL by an inkjet process.

The electronic device 1000 according to an embodiment may further include an anti-reflection layer ARL. The anti-reflection layer ARL may be disposed between the cover organic layer IJP and the window 300. The anti-reflection layer ARL may reduce reflection of light incident from the outside of the electronic device 1000. That is, the anti-reflection layer ARL may reduce external light reflectance of the electronic device 1000. The anti-reflection layer ARL according to an embodiment may include a polarization layer, a phasor, a destructive interference structure, or a plurality of color filters.

A first adhesive layer AD1 may be disposed between the anti-reflection layer ARL and the cover organic layer IJP to couple the anti-reflection layer ARL to the cover organic layer IJP. The first adhesive layer AD1 may include at least one of an optically clear adhesive, an optically clear adhesive resin, or a pressure sensitive adhesive (PSA).

The window 300 may be disposed on the anti-reflection layer ARL. A second adhesive layer AD2 may be disposed between the anti-reflection layer ARL and the window 300 to couple the anti-reflection layer ARL to the window 300. The second adhesive layer AD2 may include the same material as the first adhesive layer AD1.

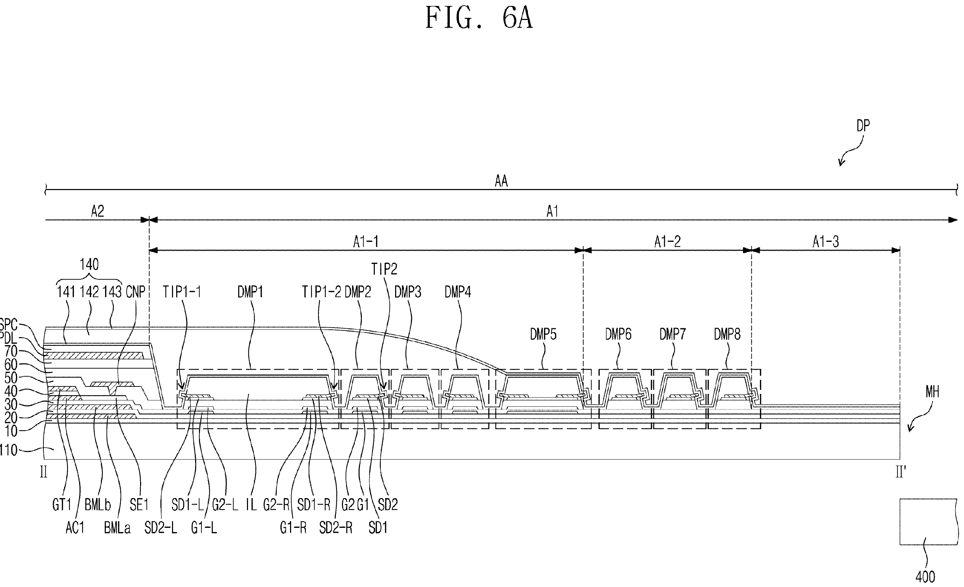

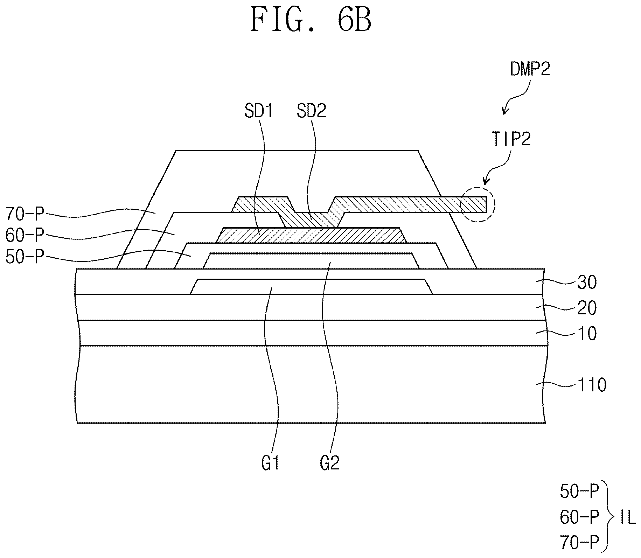

FIG. 6A is a cross-sectional view taken along line II-II' of FIG. 2. FIG. 6B is a cross-sectional view of a dam pattern according to an embodiment of the inventive concept. The same/similar reference numerals are used for the same/similar configurations as the configurations described in FIGS. 1 to 5, and redundant descriptions are omitted.

Referring to FIG. 6A, an active area AA of the display panel DP may include a margin area A1 and a pixel area A2. The margin area A1 may be defined as an area overlapping the electronic module 400, and the pixel area A2 may surround at least a portion of the margin area A1 within the active area AA. The pixel area A2 may be an area on which the pixels PX described in FIG. 2 are disposed.

The margin area A1 according to an embodiment may include a first area A1-1, a second area A1-2, and a third area A1-3. Each of the first area A1-1, the second area A1-2, and the third area A1-3 may surround the module hole MH. The first area A1-1 may be disposed closest to the pixel area A2 and may surround the second area A1-2. The third area A1-3 may be disposed closest to the module hole MH. The second area A1-2 may be disposed between the first area A1-1 and the third area A1-3.

According to an embodiment of the inventive concept, a width from the module hole MH to a boundary between the first area A1-1 and the second area A1-2 may be about 200 um or more and about 400 um or less, and a width from the module hole MH to a boundary between the second area A1-2 and the third area A1-3 may be about 50 um or more and about 150 um or less.

The module hole MH may be defined by passing through the display panel DP, the input sensor ISL (see FIG. 5), and the cover organic layer IJP (see FIG. 5). At least one of the first adhesive layer AD1, the anti-reflection layer ARL, the second adhesive layer AD2, and the window 300, which are described in FIG. 5, may cover the module hole MH to prevent side surfaces of the display panel DP, the input sensor ISL (see FIG. 5), and the cover organic layer IJP (see FIG. 5) from being exposed to the outside. For example, an opening overlapping the module hole MH may be defined in the first adhesive layer AD1 and the anti-reflection layer ARL, and the second adhesive layer AD2 and the window 300 may cover the module hole MH and the opening defined in the first adhesive layer AD1 and the anti-reflection layer ARL. According to an embodiment, a resin layer disposed inside the module hole MH may be further provided.

According to an embodiment of the inventive concept, the electronic module 400 may be disposed below the display module 100 to overlap the module hole MH. As the electronic module 400 is disposed inside the active area AA, a surface area of the peripheral area NAA of the display module 100 for disposing the electronic module 400 may be reduced.

According to an embodiment of the inventive concept, at least one dam pattern may be disposed on the first area A1-1 and the second area A1-2. As an example, five dam patterns DMP1, DMP2, DMP3, DMP4, and DMP5 may be disposed on the first area A1-1, and three dam patterns DMP6, DMP7, and DMP8 may be disposed on the second area A1-2. The dam patterns may not be disposed on the third area A1-3. However, this embodiment is an example, and the number of dam patterns disposed on the first area A1-1 and the second area A1-2 is not limited to one embodiment. On the plane, each of the dam patterns DMP 1-DMP8 may have a closed-line shape surrounding the module hole MH.

Each of the second to eighth dam patterns DMP2-DMP8 may include a first pattern SD1, a second pattern SD2, and an insulating pattern IL. Although FIG. 6B illustrates the second dam pattern DMP2 as an example, the description thereof may be applied to the third to eighth dam patterns DMP3 to DMP8.

Referring to FIG. 6B, the second dam pattern DMP2 may include a first pattern SD1, a second pattern SD2, and an insulating pattern IL. The insulating pattern IL may include a first insulating pattern 50-P, a second insulating pattern 60-P, and a third insulating pattern 70-P. The first insulating pattern 50-P may be a portion of the fifth insulating layer 50, the second insulating pattern 60-P may be a portion of the sixth insulating layer 60, and the third insulating pattern 70-P may be a portion of the seventh insulating layer 70. Thus, the first insulating pattern 50-P may be an inorganic layer, and each of the second insulating pattern 60-P and the third insulating pattern 70-P may be an organic layer.

The first insulating pattern 50-P may be disposed on the third insulating layer 30 disposed on the margin area A1. The first pattern SD1 may be disposed on the first insulating pattern 50-P. The first pattern SD1 may be disposed on the same layer as the first connection electrode CNP1 described in FIG. 5. The first pattern SD1 may be formed through the same process as the first connection electrode CNP1. Thus, the first pattern SD1 may include the same material as the first connection electrode CNP1.

The second insulating pattern 60-P may be disposed on the first pattern SD1. The second insulating pattern 60-P may be provided with an opening that exposes at least a portion of the first pattern SD1. Substantially, the second insulating pattern 60-P may be provided by applying a material forming the sixth insulating layer 60 to the entire surface of the active area AA and patterning the resultant layer to overlap the first patterns SD1. Thus, the second insulating pattern 60-P may include the same material as the sixth insulating layer 60. Each of the second insulating pattern 60-P and the sixth insulating layer 60 may include an organic material.

The second pattern SD2 may be disposed on the second insulating pattern 60-P. According to an embodiment, the second pattern SD2 may be disposed in an opening defined in the second insulating pattern 60-P so as to be in contact with the first pattern SD1 exposed from the opening. According to an embodiment, the second pattern SD2 may be disposed in the opening defined in the second insulating pattern 60-P so as to be in contact with the first pattern SD1, thereby separating at least one of the second insulating patterns 60-P provided in the second to eighth dam patterns DMP2 to DMP8 by the second pattern SD2.

The third insulating pattern 70-P may be disposed on the second pattern SD2. The third insulating pattern 70-P may overlap the second insulating pattern 60-P.

According to an embodiment, at least one of the second to fifth dam patterns DMP2 to DMP5 disposed on the first area A1-1 may further include a first dummy pattern G1 and a second dummy pattern G2. The first dummy pattern G1 may be disposed on the same layer as the second shielding electrode BMLb. The first dummy pattern G1 may be disposed between the second insulating layer 20 and the third insulating layer 30. The first dummy pattern G1 may be formed through the same process as the second shielding electrode BMLb and may include the same material as the second shielding electrode BMLb.

The second dummy pattern G2 may overlap the first dummy pattern G1. The second dummy pattern G2 may be disposed between the third insulating layer 30 and the first insulating pattern 50-P. The second dummy pattern G2 may be formed through the same process as the gate GT1 and may include the same material as the gate GT1. According to an embodiment, at least one of the first dummy pattern G1 or the second dummy pattern G2 may be omitted. In addition, it may be provided in the sixth to eighth dam patterns DMP6-DMP8 disposed on the second area A1-2, but is not limited to one embodiment.

Referring again to FIG. 6A, the first dam pattern DMP1 disposed on the first area A1-1 may include a first-1 pattern SD1-L, a first-2 pattern SD1-R, a second-1 pattern SD2-L, a second-2 pattern SD2-R, and an insulating pattern IL. The insulating pattern IL may include a first insulating pattern 50-P, a second insulating pattern 60-P, and a third insulating pattern 70-P. The description will be mainly made on other portions of the first pattern SD1, the second pattern SD2, and the insulating pattern IL provided in the above-described second dam pattern DMP2.

The first-1 pattern SD1-L and the first-2 pattern SD1-R may be disposed to be spaced apart from each other within the insulating pattern IL. The second-1 pattern SD2-L may be disposed on the first-1 pattern SD1-L, and at least a portion of the second-1 pattern SD2-L may be in contact with the first-1 pattern SD1-L. A portion of the second-1 pattern SD2-L may protrude outward from the insulating pattern IL.

According to an embodiment, the first dam pattern DMP1 may include first dummy patterns G1-L and G1-R and second dummy patterns G2-L and G2-R. The first dummy patterns G1-L and G1-R may be disposed between the second insulating layer 20 and the third insulating layer 30 so as to be spaced apart from each other. The first-1 dummy pattern G1-L may overlap the first-1 pattern SD1-L, and the first-2 dummy pattern G1-R may overlap the first-2 pattern SD1-R.

The second dummy patterns G2-L and G2-R may be disposed between the third insulating layer 30 and the fifth insulating layer 50. The second-1 dummy pattern G2-L may overlap the first-1 dummy pattern G1-L, and the second-2 dummy pattern G2-R may overlap the first-2 dummy pattern G1-R.

The second-2 pattern SD2-R may be disposed on the first-2 pattern SD1-R, and at least a portion may be in contact with the first-2 pattern SD1-R. A portion of the second-2 pattern SD2-R may protrude outward from the insulating pattern IL.

One end of the second-1 pattern SD2-L, which protrudes outward from the insulating pattern IL, and one end of the second-2 pattern SD2-R, which protrudes outward from the insulating pattern IL, may be covered by the first encapsulating inorganic layer 141.

The one end of the second-1 pattern SD2-L covered by the first encapsulating inorganic layer 141 may be defined as a first-1 tip part TIP1-1, and the one end of the covered second-2 pattern SD2-R covered by the first encapsulating inorganic layer 141 may be defined as a first-2 tip part TIP1-2.

As illustrated in FIG. 6B, one end of the second pattern SD2 provided in the second dam pattern DMP2 may protrude between the second insulating pattern 60-P and the third insulating pattern 70-P. The one end of the second pattern SD2 protruding between the second insulating pattern 60-P and the third insulating pattern 70-P may be covered by the first encapsulating inorganic layer 141. The one end of the second pattern SD2 covered by the first encapsulating inorganic layer 141 may be defined as a tip part TIP2. The description of the tip part TIP2 may be equally applied to the first dam pattern DMP1 and the third to eighth dam patterns DMP3 to DMP8.

According to an embodiment, the tip parts defined in the first to eighth dam patterns DMP1 to DMP8 may face each other. For example, the tip part TIP2 of the second dam pattern DMP2 and the tip part of the third dam pattern DMP3 may face each other, and an area between the tip parts facing each other and the insulating patterns IL may have an undercut shape in cross section. The undercut shape may surround the module hole MH. The tip parts provided in the first to eighth dam patterns DMP1-DMP8 may protrude to both sides and face each other or may protrude only to one side, and are not limited to one embodiment.

After the first to eighth dam patterns DMP1-DMP8 are formed, common layers formed through an open mask may be disconnected inside the undercut due to the tip parts, which are respectively defined in the first to eighth dam patterns DMP1-DMP8. Thus, a movement path of moisture/oxygen introduced into the module hole MH may be blocked, and thus the electronic device 1000 having improved reliability may be provided.

The first to eighth dam patterns DMP1 to DMP8 may be covered by the first encapsulating inorganic layer 141. At least one of the first to fifth dam patterns DMP1 to DMP5 disposed on the first area A1-1 may overlap the encapsulating organic layer 142. According to an embodiment, the fifth dam pattern DMP5 may define a boundary of the encapsulating organic layer 142 within the first area A1-1. The sixth to eighth dam patterns DMP6 to DMP8 may be spaced apart from the encapsulating organic layer 142.

The first encapsulating inorganic layer 141 covering the sixth to eighth dam patterns DMP6 to DMP8 may be in contact with the second encapsulating inorganic layer 143. Thus, the first encapsulating inorganic layer 141 and the second encapsulating inorganic layer 143 may be in contact from a portion of the first area A1-1 to the third area A1-3.

According to an embodiment, the first to third insulating layers 10-30 and the fifth insulating layer 50, which are provided in the driving element layer 120, may extend up to the third area A1-3 so as to be in contact with the third area A1-3. However, this embodiment is not limited to this, and at least one of the first to fifth insulating layers 10 to 50 may be omitted on the third area A1-3.

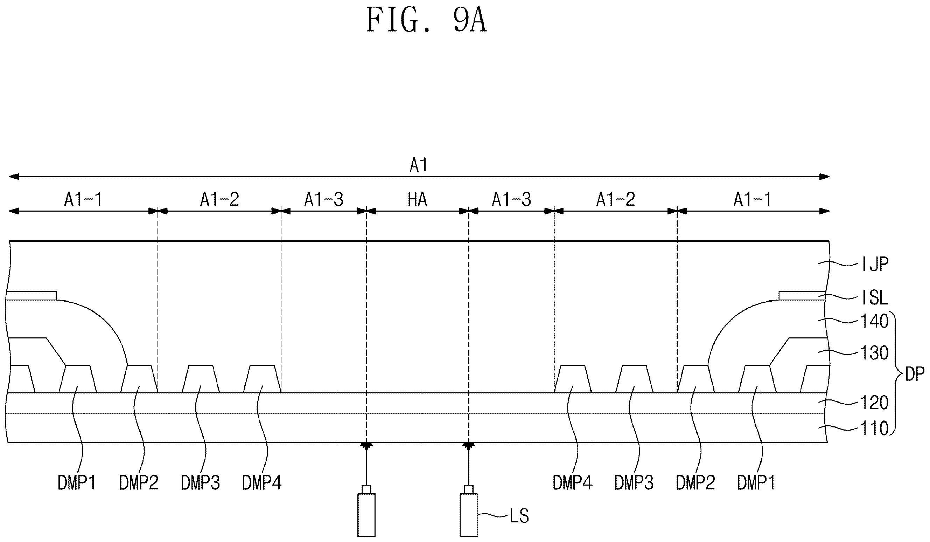

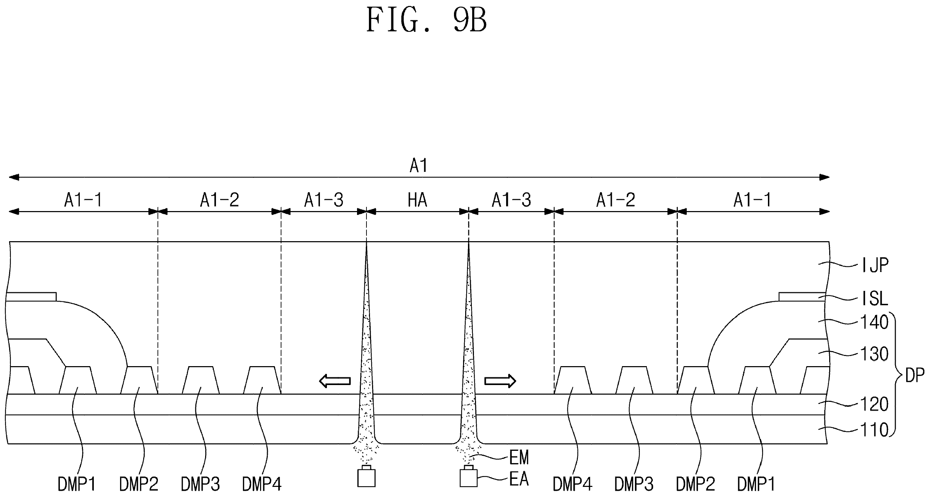

FIGS. 9A and 9B briefly illustrate a process for forming a module hole MH in an electronic device 1000 according to an embodiment of the inventive concept. For convenience of explanation, only a display panel DP, an input sensor ISL, and a cover organic layer IJP are illustrated, and four dam patterns DMP1 and DMP4 disposed on first and second dam areas A1-1 and A1-2 are illustrated as an example. According to this embodiment, a base layer 110 provided in the display panel DP may include glass.

Referring to FIG. 9A, a margin area A1 of the display panel DP may include a first area A1-1, a second area A1-2, a third area A1-3, and a hole processing area HA.

A width from a boundary between the hole processing area HA and the third area A1-3 to a boundary between the first area A1-1 and the second area A1-2 may be about 200 um or more and about 400 um or less, and a width from a boundary between the hole processing area HA and the third area A1-3 to a boundary between the second area A1-2 and the third area A1-3 may be about 50 um or more and about 150 um or less.

According to an embodiment of the inventive concept, in a process of forming the first module hole, a laser device LS may be disposed on a rear surface of the display panel DP and then irradiate laser beam along the boundary between the third area A1-3 and the hole processing area HA. This may be a process of sketching an area on which the module hole MH (see FIG. 6A) will be formed using the laser device LS. When the laser beam is irradiated, peeling may occur between the first to fifth insulating layers 10 to 50 (see FIG. 5) provided in the driving element layer 120. According to an embodiment of the inventive concept, a peeling phenomenon in which the first to fifth insulating layers 10 and 50 (see FIG. 5) are peeled from the boundary between the third area A1-3 and the hole processing area HA in a direction toward the pixel area A2 may be prevented at tip parts defined in the dam patterns DMP1 to DMP8.

Thereafter, referring to FIG. 9B, a groove through which at least a portion of the display panel DP and the cover organic layer IJP passes may be formed in the boundary between the third area A1-3, to which the laser beam is irradiated, and the hole processing area HA. An etchant EM may be injected into the groove through an etching device EA. Here, the etchant EM may be introduced between the first to fifth insulating layers 10 to 50 (see FIG. 5) that are peeled off during the process of irradiating the laser beam.

According to an embodiment of the inventive concept, a width between the first area A1-1 and the second area A1-2 from the module hole MH may be about 200 um or more and about 400 um or less, and as the dam patterns DMP3 and DMP4 are disposed on the second area A1-2, the etchant EM may be introduced between the first to fifth insulating layers 10 to 50 (see FIG. 5), which are peeled, to prevent an emission layer EL and a cathode CE, which are provided in a light emitting element LD, from being damaged. Thus, even if the module hole MH is formed inside an active area AA, the electronic device 1000 having improved display quality and reliability may be provided.

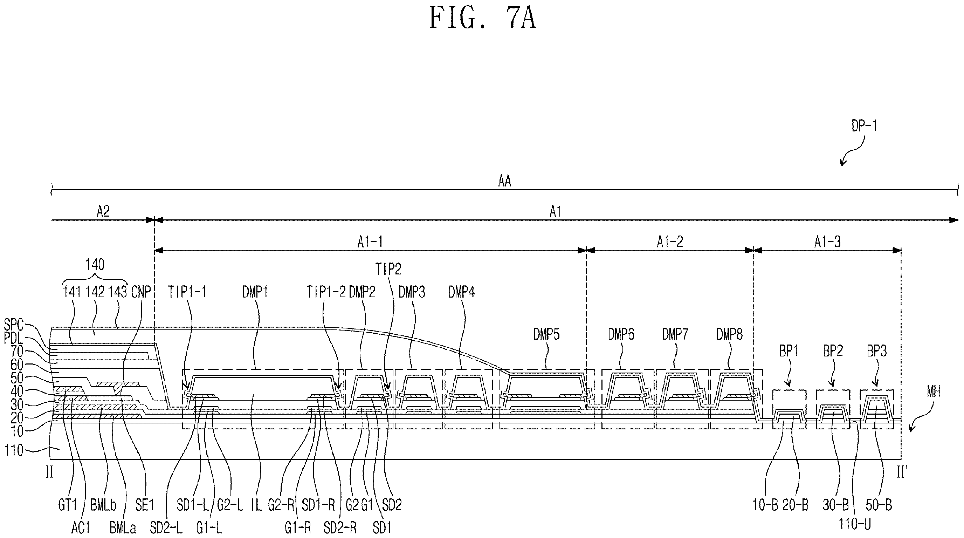

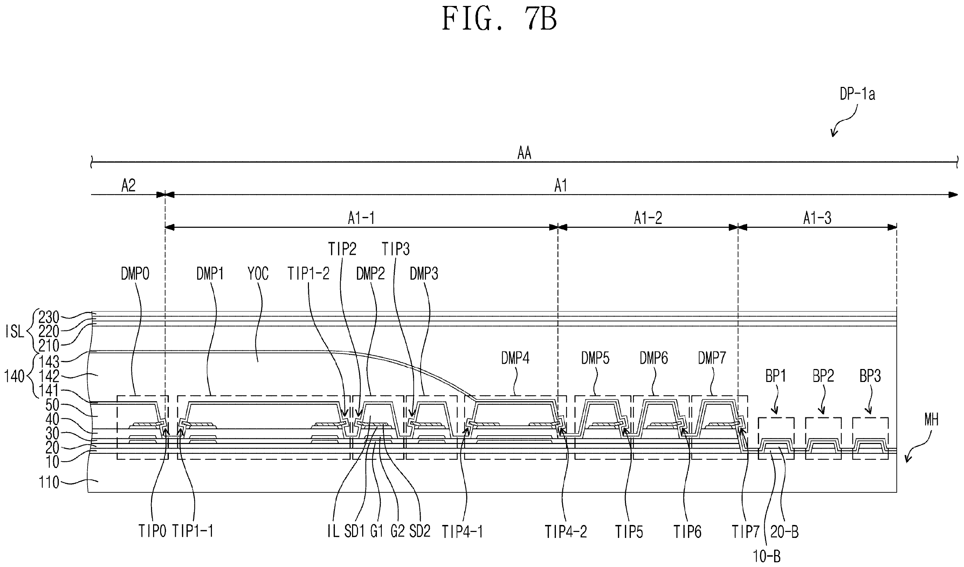

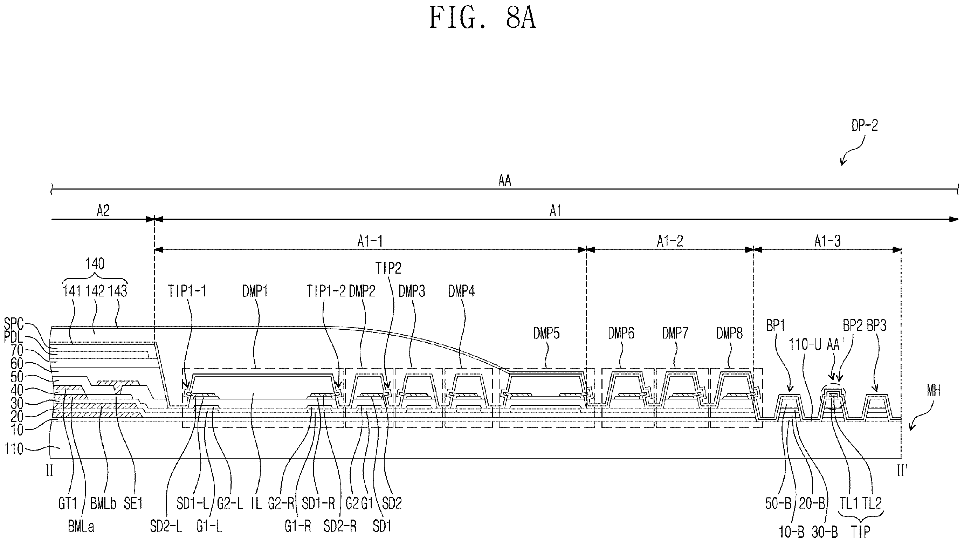

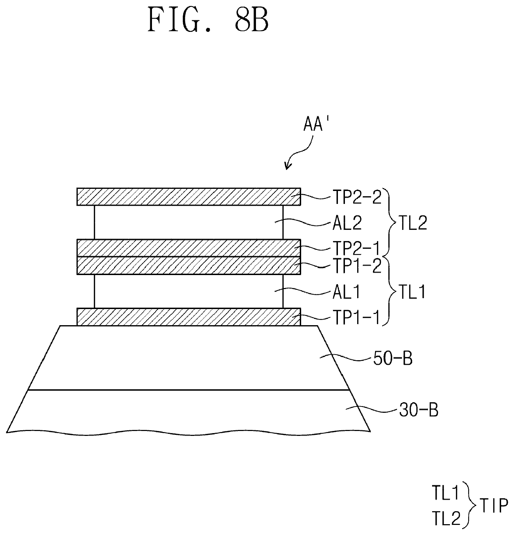

FIG. 7A is a cross-sectional view of the display panel according to an embodiment of the inventive concept. FIG. 7B is a cross-sectional view of a display panel according to an embodiment of the inventive concept. FIG. 8A is a cross-sectional view of a display panel according to an embodiment of the inventive concept. FIG. 8B is an enlarged plan view of an area AA' of FIG. 8A. The same/similar reference numerals are used for the same components as those of FIGS. 1 to 6B, and thus, their duplicated descriptions will be omitted.

Referring to FIG. 7A, an active area AA of a display panel DP-1 according to an embodiment may include a margin area A1 and a pixel area A2. The margin area A1 may be defined as an area overlapping the electronic module 400, and the pixel area A2 may surround at least a portion of the margin area A1 within the active area AA. The margin area A1 may surround a module hole MH within the active area AA.

According to an embodiment of the inventive concept, at least one dam pattern may be disposed on the first area A1-1 and the second area A1-2. As an example, first to fifth dam patterns DMP1, DMP2, DMP3, DMP4, and DMP5 may be disposed on the first area A1-1, and sixth to eighth dam patterns DMP6, DMP7, and DMP8 may be disposed on the second area A1-2. The dam patterns may not be disposed on the third area A1-3. However, this embodiment is an example, and the number of dam patterns disposed on the first area A1-1 and the second area A1-2 is not limited to one embodiment.

The display panel DP-1 according to an embodiment may further include blocking patterns BP1, BP2, and BP3 disposed on the third area A1-3. Each of the blocking patterns BP1, BP2, and BP3 may include a plurality of inorganic layers.

For example, the first blocking pattern BP1 may include a first pattern layer 10-B and a second pattern layer 20-B, the second blocking pattern BP2 may include a first pattern layer 10-B, a second pattern layer 20-B, and a third pattern layer 30-B, and a third blocking pattern BP3 may include a first pattern layer 10-B, a second pattern layer 20-B, a third pattern layer 30-B, and a fourth pattern layer 50-B.

However, this embodiment is not limited to this, and the blocking patterns BP1, BP2, and BP3 may include the same pattern layers, for example, may include at least one of the first to fourth pattern layers. In addition, a portion of the fourth insulating layer 40 patterned using a gate GT1 as a mask may be provided in the blocking patterns BP1, BP2, and BP3.

The first pattern layer 10-B may be a portion of a first insulating layer 10, the second pattern layer 20-B may be a portion of a second insulating layer 20, and the third pattern layer 30-B may be a portion of a third insulating layer 30. The fourth pattern layer 50-B may be a portion of a fifth insulating layer 50.

The blocking patterns BP1, BP2, and BP3 may be spaced apart from each other to expose a top surface 110-U of a base layer 110. The top surface 110-U may be covered by a first encapsulating inorganic layer 141. Each of the blocking patterns BP1, BP2, and BP3 may have a closed-line shape surrounding a module hole MH on a plane.

The blocking patterns BP1, BP2, and BP3 may be formed at the same time as a process of forming a contact hole in the fifth insulating layer 50 to connect a connection electrode CNP disposed on the fifth insulating layer 50 to a semiconductor pattern. That is, the first to third insulating layers 10, 20, and 30 disposed on the third area A1-3 and the blocking patterns BP1, BP2, and BP3, which are spaced apart from each other by patterning the fifth insulating layer 50, may be formed in the same process as the process of forming the contact hole in the fifth insulating layer 50.

According to an embodiment, in addition to dam patterns DMP1 to DMP8, the blocking patterns BP1, BP2, and BP3, which are spaced apart from each other on the third area A1-3 and surround the module hole MH, may be further provided to primarily prevent a peeling phenomenon that occurs between the insulating layers 10 to 50 in the process of irradiating the laser beam through the laser device LS (see FIG. 9A) from occurring in the third area A1-3. In addition, in a process of injecting an etchant EM (see FIG. 9B) through an etching device EA (see FIG. 9B), a limitation in which the etchant is permeated between the peeled insulating layers 10 and 50 may be improved. Thus, even if the module hole MH is formed inside an active area AA, the electronic device 1000 having improved display quality and reliability may be provided.

Referring to FIG. 7B, an active area AA of a display panel DP-1a according to an embodiment may include a margin area A1 and a pixel area A2. The margin area A1 may be defined as an area overlapping the electronic module 400 (see FIG. 7A), and the pixel area A2 may surround at least a portion of the margin area A1 within the active area AA. The margin area A1 may surround a module hole MH within the active area AA.

According to an embodiment of the inventive concept, at least one dam pattern may be disposed on the first area A1-1 and the second area A1-2. As an example, first to fourth dam patterns DMP1, DMP2, DMP3, and DMP4 may be disposed on the first area A1-1, and fifth to seventh dam patterns DMP5, DMP6, and DMP7 may be disposed on the second area A1-2. The dam patterns may not be disposed on the third area A1-3. However, this embodiment is an example, and the number of dam patterns disposed on the first area A1-1 and the second area A1-2 is not limited to one embodiment. In this embodiment, the first dam pattern DMP1 and the second dam pattern DMP2 may correspond to the first dam pattern DMP1 and the second dam pattern DMP2 described in FIGS. 6A and 7A, and thus, duplicated descriptions will be omitted.

The display panel DP-1a according to this embodiment may further include a sub dam pattern DMP0 (0th dam pattern) disposed adjacent to a boundary between the margin area A1 and the pixel area A2 on the pixel area A2. The sub dam pattern DMP0 may include a first pattern SD1 disposed on the fourth insulating layer 40 and a second pattern SD2 disposed on the first pattern SD1. One side of the second pattern SD2 may protrude between the fourth and fifth insulating layers 40 and 50 and may be defined as a sub tip part TIP0. The sub tip part TIP0 may be covered by a first encapsulating inorganic layer 141. The sub dam pattern DMP0 may further include a first dummy pattern G1 disposed on the second insulating layer 20 and a second dummy pattern G2 overlapping the first dummy pattern G1 and disposed on the third insulating layer 30.

According to this embodiment, the sub tip part TIP0 may have an undercut shape by facing a first-1 tip part TIP1-1 defined in the first dam pattern DMP1. A first-2 tip part TIP 1-2 defined in the first dam pattern DMP1 may have an undercut shape by facing a second tip part TIP2 of the second dam pattern DMP2.

A third tip part TIP3 defined in the third dam pattern DMP3 may protrude in a direction toward the second dam pattern DMP2. A fourth-1 tip part TIP4-1 defined in the fourth dam pattern DMP4 may protrude in a direction toward the third dam pattern DMP3. A fourth-2 tip part TIP4-2 defined in the fourth dam pattern DMP4 may protrude in a direction toward the fifth dam pattern DMP5. A fifth tip part TIPS defined in the fifth dam pattern DMP5 may protrude in a direction toward the sixth dam pattern DMP6. A sixth tip part TIP6 defined in the sixth dam pattern DMP6 may protrude in a direction toward the seventh dam pattern DMP7. A seventh tip part TIP7 defined in the seventh dam pattern DMP7 may protrude in a direction toward the module hole MH.

After the 0th to seventh dam patterns DMP0 to DMP7 are formed, common layers formed through an open mask may be disconnected inside the undercut due to the tip parts, which are respectively defined in the 0th to seventh dam patterns DMP0 to DMP7. Thus, a movement path of moisture/oxygen introduced into the module hole MH may be blocked, and thus the electronic device 1000 having improved reliability may be provided.

The 0th to 7th dam patterns DMP0 to DMP7 may be covered by the first encapsulating inorganic layer 141. At least one of the 0th to 4th dam patterns DMP0 to DMP4 may overlap the encapsulating organic layer 142. According to an embodiment, the fourth dam pattern DMP4 may define a boundary of the encapsulating organic layer 142 within the first area A1-1. The fifth to seventh dam patterns DMP5 to DMP7 may be spaced apart from the encapsulating organic layer 142.

The first encapsulating inorganic layer 141 covering the fifth to seventh dam patterns DMP5 to DMP7 may be in contact with the second encapsulating inorganic layer 143. Thus, the first encapsulating inorganic layer 141 and the second encapsulating inorganic layer 143 may be in contact from a portion of the first area A1-1 to the third area A1-3.

The display panel DP-1a according to an embodiment may further include blocking patterns BP1, BP2, and BP3 disposed on the third area A1-3. Each of the blocking patterns BP1, BP2, and BP3 may include a plurality of inorganic layers.

For example, each of the blocking patterns BP1, BP2, and BP3 may include a first pattern layer 10-B and a second pattern layer 20-B. The first pattern layer 10-B may be a portion of a first insulating layer 10, and the second pattern layer 20-B may be a portion of a second insulating layer 20.

The blocking patterns BP1, BP2, and BP3 may be spaced apart from each other to expose a top surface of a base layer 110. The top surface exposed between the blocking patterns BP1, BP2, and BP3 may be covered by the first encapsulating inorganic layer 141. Each of the blocking patterns BP1, BP2, and BP3 may have a closed-line shape surrounding a module hole MH on a plane.

According to an embodiment, in addition to the dam patterns DMP0 to DMP7, the blocking patterns BP1, BP2, and BP3, which are spaced apart from each other on the third area A1-3 and surround the module hole MH, may be further provided to primarily prevent a peeling phenomenon that occurs between the insulating layers 10 to 50 in the process of irradiating the laser beam through the laser device LS (see FIG. 9A) from occurring in the third area A1-3. In addition, in a process of injecting an etchant EM (see FIG. 9B) through an etching device EA (see FIG. 9B), a limitation in which the etchant is permeated between the peeled insulating layers 10 and 50 may be improved. Thus, even if the module hole MH is formed inside an active area AA, the electronic device 1000 having improved display quality and reliability may be provided.

According to this embodiment, a planarization layer YOC disposed between an encapsulation layer 140 and a first insulating layer 210 of an input sensor ISL may be further provided. The planarization layer YOC may compensate for a height difference occurring in the process of forming the dam patterns DMP0 to DMP7 and the blocking patterns BP1, BP2, and BP3 adjacent to the margin area A1. Thus, the first to third insulating layers 210, 220, and 230 and conductive lines of the input sensor ISL disposed on the planarization layer YOC may be formed on a flat surface. According to an embodiment, the planarization layer YOC may be in contact with the second encapsulating inorganic layer 143 on the margin area A1.

Referring to FIG. 8A, an active area AA of a display panel DP-2 according to an embodiment may include a margin area A1 and a pixel area A2. The margin area A1 may be defined as an area overlapping the electronic module 400, and the pixel area A2 may surround at least a portion of the margin area A1 within the active area AA. The margin area A1 may surround a module hole MH within the active area AA.

According to an embodiment of the inventive concept, at least one dam pattern may be disposed on the first area A1-1 and the second area A1-2. As an example, first to fifth dam patterns DMP1, DMP2, DMP3, DMP4, and DMP5 may be disposed on the first area A1-1, and sixth to eighth dam patterns DMP6, DMP7, and DMP8 may be disposed on the second area A1-2. The dam patterns may not be disposed on the third area A1-3. However, this embodiment is an example, and the number of dam patterns disposed on the first area A1-1 and the second area A1-2 is not limited to one embodiment.

The display panel DP-1 according to an embodiment may further include blocking patterns BP1, BP2, and BP3 disposed on the third area A1-3. Each of the blocking patterns BP1, BP2, and BP3 may include a plurality of inorganic layers. Descriptions of the dam patterns DMP1 to DMP8 and blocking patterns BP1, BP2, and BP3 may correspond to those of the dam patterns DMP1 to DMP8 and the blocking patterns BP1, BP2, and BP3 described in FIGS. 6A to 7A.

The display panel DP-2 according to this embodiment may further include a tip pattern TIP disposed on the third area A1-3. The tip pattern TIP may be disposed on the blocking patterns BP1, BP2, and BP3 and may be provided in plurality. The tip pattern TIP may include a first pattern TL1, which is also termed as a first tip pattern TL1, and a second pattern TL2, which is also termed as a second tip pattern TL2.

The first pattern TL1 may be provided as a multiple layer in which one layer containing three materials is provided in plurality, and the second pattern TL2 may be provided as a multiple layer in which one layer containing three materials is provided in plurality. The first pattern TL1 may be formed through the same process as a first connection electrode CNP1 described in FIG. 5 and may include the same material. In addition, the second pattern TL2 may be formed in the same process as a second connection electrode CNP2 and may include the same material.

Referring to FIG. 8B, the first pattern TL1 may be disposed on a fourth pattern layer 50-B. The first pattern TL1 may include a first-1 conductive pattern TP1-1 (which may be termed as a first first conductive pattern), a first-2 conductive pattern TP1-2 (which may be termed as a second first conductive pattern), and a first intermediate pattern AL1. Each of the first-1 conductive pattern TP1-1 and the first-2 conductive pattern TP 1-2 may include titanium, and the first intermediate pattern AL1 may include aluminum.

The first-1 conductive pattern TP1-1 and the first-2 conductive pattern TP 1-2 may protrude outward from a side surface of the first intermediate pattern AL1. This shape may be formed due to a difference in etching rate.

The second pattern TL2 may be disposed on the first pattern TL1. The second pattern TL2 may include a second-1 conductive pattern TP2-1 (which may be termed as a first second conductive pattern), a second-2 conductive pattern TP2-2 (which may be termed as a second second conductive pattern), and a second intermediate pattern AL2. Each of the second-1 conductive pattern TP2-1 and the second-2 conductive pattern TP2-2 may include titanium, and the second intermediate pattern AL2 may include aluminum.

The second-1 conductive pattern TP2-1 and the second-2 conductive pattern TP2-2 may protrude outward from a side surface of the second intermediate pattern AL2. This shape may be formed due to a difference in etching rate. The first pattern TL1 and the second pattern TL2 may be covered by a first encapsulating inorganic layer 141.

According to this embodiment, an etchant EM (see FIG. 9B) may be prevented from being introduced into the display panel DP-2 in the etching process described in FIG. 9B due to the structure formed by the etching rate between the layers provided in the first pattern TL1 and the second pattern TL2.

According to an embodiment of the inventive concept, the dam area which has the predetermined width or more from the module hole and on which the dam patterns are disposed may be limited to prevent the etchant from being introduced between the insulating layers. Therefore, even if the module hole is defined within the active area, the electronic device having the improved display quality and reliability may be provided.

It will be apparent to those skilled in the art that various modifications and deviations can be made in the inventive concept. Thus, it is intended that the inventive concept covers the modifications and deviations of this invention provided they come within the scope of the appended claims.

Accordingly, the technical scope of the inventive concept should not be limited to the contents described in the detailed description of the specification, but should be determined by the claims.

## Claims

1. An electronic device (1000) comprising:
a display module (100) comprising a base layer (110), which comprises a margin area (A1) and a pixel area (A2) that surrounds the margin area (A1), and pixels (PX) disposed on the pixel area (A2); and
a cover organic layer (IJP) disposed on the display module (100) and overlapping the margin area (A1),
wherein a module hole (MH) is defined by passing through the display module (100) and the cover organic layer (IJP),
the margin area (A1) is divided into a first area (A1-1) adjacent to the pixel area (A2), a second area (A1-2) that is surrounded by the first area (A-1), and a third area (A1-3) that surrounds the module hole (MH) and is disposed between the second area (A1-2) and the module hole (MH), and
the display module (100) comprises dam patterns (DMP1-DMP8) disposed on at least one of the first area (A1-1) and the second area (A1-2),
wherein each of the dam patterns (DMP1-DMP8) comprises a first insulating pattern (50-P), a first pattern (SD1) disposed on the first insulating pattern (50-P), a second insulating pattern (60-P) having an opening exposing at least a portion of the first pattern (SD1), a second pattern (SD2) disposed on the second insulating pattern (60-P) and in contact with the first pattern (SD1) through the opening, and a third insulating pattern (70-P) configured to cover the second pattern (SD2).

2. The electronic device (1000) of claim 1, wherein a width from the module hole (MH) to the second area (A1-2) is about 200 um or more and about 400 um or less.

3. The electronic device (1000) of claim 1 or 2, wherein a width from the module hole (MH) to the third area (A1-3) is about 50 um or more and about 150 um or less.

4. The electronic device (1000) of at least one of claims 1 to 3, wherein at least one of two opposing sides of the second pattern (SD2) protrudes outward from between the second insulating pattern (60-P) and the third insulating pattern (70-P).

5. The electronic device (1000) of at least one of claims 1 to 4, wherein each of the dam patterns (DMP1-DMP8) is surround the module hole (MH).

6. The electronic device (1000) of at least one of claims 1 to 5, wherein the display module (100) comprises:
a first insulating layer (10) disposed on the base layer (110);
a first shielding electrode (BMI,a) disposed on the first insulating layer (10);
a second insulating layer (20) configured to cover the first shielding electrode (BMI,a) and disposed on the first insulating layer (10);
a second shielding electrode (BMI,b) disposed on the second insulating layer (20) and overlapping the first shielding electrode (BMI,a);
a third insulating layer (30) configured to cover the second shielding electrode (BMLb) and disposed on the second insulating layer (20);
a semiconductor pattern (SC) disposed on the third insulating layer (30);
a fourth insulating layer (40) disposed on a portion of the semiconductor pattern (SC);
a gate (GT1) disposed on the fourth insulating layer (40);
a fifth insulating layer (50) configured to cover the gate (GT1);
a first connection electrode (CNP1) disposed on the fifth insulating layer (50) and connected to the semiconductor pattern (SC) through a first contact hole defined in the fifth insulating layer (50);
a sixth insulating layer (60) configured to cover the first connection electrode (CNP1) and disposed on the fifth insulating layer (50);
a second connection electrode (CNP2) disposed on the sixth insulating layer (60) and connected to the first connection electrode (CNP1) through a second contact hole defined in the sixth insulating layer (60);
a seventh insulating layer (70) configured to cover the second connection electrode (CNP2) and disposed on the sixth insulating layer (60); and
a light emitting element (LD) disposed on the seventh insulating layer (70) and connected to the second connection electrode (CNP2).

7. The electronic device (1000) of claim 6, wherein each of the first to fifth insulating layers (10, 20, 30, 40, 50) comprises an inorganic material, and
each of the sixth insulating layer (60) and the seventh insulating layer (70) comprises an organic material.

8. The electronic device (1000) of claim 6 or 7, wherein the first pattern (SD1) comprises the same material as the first connection electrode (CNP1),
the second pattern (SD2) comprises a same material as the second connection electrode (CNP2),
the first insulating pattern (50-P) comprises a same material as the fifth insulating layer (50),
the second insulating pattern (60-P) comprises a same material as the sixth insulating layer (60), and
the third insulating pattern (70-P) comprises a same material as the seventh insulating layer (70).

9. The electronic device (1000) of at least one of claims 6 to 8, wherein the first connection electrode (CNP1) is connected to the second shielding electrode (BMLb) through a contact hole defined in the third insulating layer (30) and the fifth insulating layer (50).

10. The electronic device (1000) of at least one of claims 6 to 9, wherein the display module (100) further comprises an encapsulation layer (140) comprising a first encapsulating inorganic layer (141) configured to cover the light emitting element (LD), an encapsulating organic layer (142) disposed on the first encapsulating inorganic layer (141), and a second encapsulating inorganic layer (143) disposed on the encapsulating organic layer (142), and
the dam patterns (DMP1-DMP8) are covered by the first encapsulating inorganic layer (141).

11. The electronic device (1000) of claim 10, wherein the dam patterns (DMP1-DMP8) disposed on the first area (A1-1) overlap the encapsulating organic layer (142), and
the dam patterns (DMP1-DMP8) disposed on the second area (A1-2) are spaced apart from the encapsulating organic layer (142).

12. The electronic device (1000) of claim 10 or 11, wherein the first encapsulating inorganic layer (141) configured to cover the dam patterns (DMP1-DMP8) is in contact with the second encapsulating inorganic layer (143) on the second area (A1-2).

13. The electronic device (1000) of at least one of claims 6 to 12, wherein the display module (100) further comprises blocking patterns (BP1, BP2, BP3) each of which surrounds the module hole (MH) and which are spaced apart from each other,
wherein each of the blocking patterns (BP1, BP2, BP3) comprises at least one of:
a first pattern layer (10-B) comprising the same material as the first insulating layer (10);
a second pattern layer (20-B) comprising the same material as the second insulating layer (20);
a third pattern layer (30-B) comprising the same material as the third insulating layer (30); or
a fourth pattern layer (50-B) comprising the same material as the fifth insulating layer (50).

14. The electronic device (1000) of claim 13, wherein the blocking patterns (BP1, BP2, BP3) are spaced apart from each other to expose a top surface of the base layer (110).

15. The electronic device (1000) of claim 14, wherein the first encapsulating inorganic layer (141) is configured to cover the top surface of the base layer (110), which is exposed from the blocking patterns (BP1, BP2, BP3).

16. The electronic device (1000) of at least one of claims 1 to 15, further comprising a tip pattern (TIP) disposed on the blocking patterns (BP1, BP2, BP3),
wherein the tip pattern (TIP) comprises a first tip pattern (TL1) and a second tip pattern (TL2), which are sequentially laminated,
each of the first tip pattern (TL1) and the second tip pattern (TL2) of the tip pattern (TIP) comprises a first conductive pattern (TP1-1, TP2-1), a second conductive pattern (TP1-2, TP2-2) disposed on the first conductive pattern (TP1-1, TP2-1), and an intermediate pattern (AL1, AL2) disposed between the first conductive pattern (TP1-1, TP2-1) and the second conductive pattern (TP1-2, TP2-2), and
the first conductive pattern (TP1-1, TP2-1) and the second conductive pattern (TP1-2, TP2-2) protrude outward from the intermediate pattern (AL1, AL2).

17. The electronic device (1000) of claim 16, wherein each of the first conductive pattern (TP1-1, TP2-1) and the second conductive pattern (TP1-2, TP2-2) comprises titanium, and
the intermediate pattern (AL1, AL2) comprises aluminum.

18. The electronic device (1000) of at least one of claims 1 to 17, further comprising an electronic module that overlaps the module hole (MH) and is disposed below the display module (100).

19. An electronic device (1000) comprising
a display module (100) comprising
a display panel comprising a base layer (110), which comprises a margin area (A1) and a pixel area (A2) that surrounds the margin area (A1), a driving element layer (120) comprising first to seventh insulating layer (10, 20, 30, 40, 50, 60, 70) and a transistor (TFT), which are disposed on the base layer (110), a light emitting element layer (130) comprising a pixel defining layer (PDL) and a light emitting element (LD), which are disposed on the driving element layer (120), and an encapsulation layer (140) configured to cover the light emitting element (LD); and
an input sensor (ISL) disposed on the display panel,
the electronic device (1000) further comprising
a cover organic layer (IJP) disposed on the display module (100) and overlapping the margin area (A1),
wherein a module hole (MH) is defined by passing through the display module (100) and the cover organic layer (IJP),
the margin area (A1) is divided into a first area (A1-1) adjacent to the pixel area (A2), a second area (A1-2) that is surrounded by the first area (A1-1), and a third area (A1-3) that surrounds the module hole (MH) and is disposed between the second area (A1-2) and the module hole (MH), and
the display panel comprises dam patterns (DMP1-DMP8) disposed on at least one of the first area (A1-1) and the second area (A1-2) and blocking patterns (BP1, BP2, BP3) disposed on the third area (A1-3),
wherein each of the blocking patterns (BP1, BP2, BP3) comprises a first pattern layer (10-B) disposed on the base layer (110) and a second pattern layer (20-B) disposed on the first pattern layer (10-B), and the blocking patterns (BP1, BP2, BP3) are spaced apart from each other to surround the module hole (MH).

20. The electronic device (1000) of claim 19, wherein each of the first to fifth insulating layers (10, 20, 30, 40, 50) comprises an inorganic material,
each of the sixth insulating layer (60) and the seventh insulating layer (70) comprises an organic material,
the first pattern layer (10-B) comprises a same material as the first insulating layer (10), and
the second pattern layer (20-B) comprises a same material as the second insulating layer (20).

21. The electronic device (1000) of claim 19 or 20, wherein each of the dam patterns (DMP1-DMP8) comprises a first insulating pattern (50-P) disposed on the third insulating layer (30), a first pattern (SD1) disposed on the first insulating pattern (50-P), a second insulating pattern (60-P) in which an opening exposing at least a portion of the first pattern (SD1) is defined, a second pattern (SD2) disposed the second insulating pattern (60-P) and in contact with the first pattern (SD1) through the opening, and a third insulating pattern (70-P) configured to cover the second pattern (SD2),
the first insulating pattern (50-P) comprises a same material as the fifth insulating layer (50),
the second insulating pattern (60-P) comprises a same material as the sixth insulating layer (60), and
the third insulating pattern (70-P) comprises a same material as the seventh insulating layer (70).

22. The electronic device (1000) of at least one of claims 19 to 21, wherein the encapsulation layer (140) comprises a first encapsulating inorganic layer (141) configured to cover the light emitting element (LD), a second encapsulating inorganic layer (143) disposed on the first encapsulating inorganic layer (141), and an encapsulating organic layer (142) disposed between the first encapsulating inorganic layer (141) and the second encapsulating inorganic layer (143), and
the electronic device (1000) further comprises a planarization layer (YOC) disposed between the second encapsulating inorganic layer (143) and the input sensor (ISL).
a laser process of forming the module hole (MH) from occurring.

23. The electronic device (1000) of at least one of claims 6 to 22, wherein at least one of the dam patterns (DMP1-DMP8) disposed on the first area (A1-1) further comprises:
a first dummy pattern (G1) disposed between the second insulating layer (20) and the third insulating layer (30); and
a second dummy pattern (G2) that overlaps the first dummy pattern (G1) and is disposed between the third insulating layer (30) and the first insulating pattern (50-P).

24. The electronic device (1000) of at least one of claims 13 to 23, wherein the blocking pattern (BP1, BP2, BP3) is configured to prevent peeling that occurs in the first to seventh insulating layers (10, 20, 30, 40, 50, 60, 70) during a laser process of forming the module hole (MH) from occurring.
